# EUROPEAN PATENT APPLICATION

(11) **EP 2 752 882 A1**
(43) Date of publication of application: **09.07.2014**
(21) Application number: 12827152.5
(22) Date of filing: 30.08.2012
(51) Int. Cl.: H01L 31/04

(54) **COMPUTATION DEVICE WHICH OPTIMIZES SOLAR POWER GENERATION, METHOD WHICH OPTIMIZES SOLAR POWER GENERATION, SOLAR POWER GENERATION SYSTEM, AND SOLAR POWER GENERATION SIMULATION SYSTEM**

(30) Priority: 30.08.2011 JP 2011187922
(71) Applicant: JX Nippon Oil & Energy Corporation, Chiyoda-ku Tokyo 100-8162 (JP); National Institute of Advanced Industrial Science and Technology, Tokyo 100-8921 (JP)
(72) Inventor: ISHII Takafumi, Tokyo 100-8162 (JP); OOZEKI Takashi, Tsukuba-shi Ibaraki 305-8568 (JP); YAMADA Takao, Tsukuba-shi Ibaraki 305-8568 (JP); OBANE Hideaki, Nakatsugwa-shi Gifu 508-8666 (JP); OKAJIMA Keiichi, Tsukuba-city Ibaraki 305-8573 (JP)
(74) Representative: Grünecker, Kinkeldey, Stockmair & Schwanhäusser
(86) International application number: PCT/JP2012/072053
(87) International publication number: WO 2013/031914

(57) **Abstract**

Disclosed is a computation device for optimizing photovoltaic power generation by computing a wire connection pattern of a plurality of photovoltaic modules, the computation device including a parameter acquisition unit configured to acquire a parameter including at least a current value from each of the photovoltaic modules; a class classification unit configured to perform class classification of the photovoltaic modules based on the parameter acquired by the parameter acquisition unit; and a wire connection pattern selection unit configured to select the wire connection pattern based on the class classification performed by the class classification unit.

## Description

### Technical Field

The present invention relates to a computation device which optimizes photovoltaic power generation, a method which optimizes photovoltaic power generation, a photovoltaic power generation system, and a photovoltaic power generation simulation system.

### Background Art

From the conventional art, a photovoltaic power generation system in which a plurality of photovoltaic modules are connected to each other to form an array, and which generates electric power by sunlight has been known. In such a photovoltaic power generation system, when an effect of shade partially generated by surrounding trees and buildings, individual differences or incidence angles of photovoltaic circuits, or the like is not considered, the photovoltaic module cannot fully use a performance thereof. Accordingly, a photovoltaic power generation system according to Patent Literature 1 measures parameters (a current value and a voltage value) of the photovoltaic modules to optimize a wire connection pattern based on the corresponding measured result.

### Patent Literature

Japanese Patent Laid-Open Publication No. 2010-219349

### Summary of Invention

### Technical Problem

Meanwhile, in recent years, the number of photovoltaic modules included in a photovoltaic power generation system increases. However, in an optimization method according to the related art, when the number of photovoltaic modules increases, the number of wire connection patterns to be considered sharply increases. When it is desired to select an optimal wire connection pattern among the wire connection patterns, there are problems in that a computation load increases, a computation time is very long, an amount of a memory mounted to a computation device is lacking, etc..

Accordingly, the present invention has been made to solve the above-mentioned problems, and an aspect of the present invention is to provide a computation device which optimizes photovoltaic power generation, a method which optimizes photovoltaic power generation, a photovoltaic power generation system, and a photovoltaic power generation simulation system, which can improve a power generation performance of the photovoltaic power generation while reducing a computation load by effectively selecting a wire connection pattern.

### Solution to Problem

A computation device for optimizing photovoltaic power generation according to an aspect of the present invention corresponds to a computation device for optimizing photovoltaic power generation by computing a wire connection pattern of a plurality of photovoltaic modules, and includes a parameter acquisition unit configured to acquire a parameter including at least a current value from each of the photovoltaic modules; a class classification unit configured to perform class classification of the photovoltaic modules based on the parameter acquired by the parameter acquisition unit; and a wire connection pattern selection unit configured to select the wire connection pattern based on the class classification performed by the class classification unit.

In the computation device according to an aspect of the present invention, the class classification unit performs the class classification of the photovoltaic modules based on the parameter including at least a current value of each of the photovoltaic modules. That is, since the optimization of the wire connection pattern of each of the classes may be performed by performing the class classification even when the number of the photovoltaic modules increases, a computation load is reduced as compared with a case of performing computation after organizing the wire connection pattern of the plurality of photovoltaic modules. Accordingly, the wire connection pattern is effectively selected, so that the power generation performance of the photovoltaic power generation is improved while the computation load is reduced.

Further, in the computation device according to another aspect of the present invention, the class classification unit classifies the photovoltaic modules having the similar parameter into the same class. Accordingly, a string and an array may be configured by using the photovoltaic modules M within each of the classes, which have similar parameters, it becomes easy to perform optimization of the wire connection pattern, and it becomes easy to form a wire connection pattern which may effectively use an output of each of the photovoltaic modules without a waste at the same time.

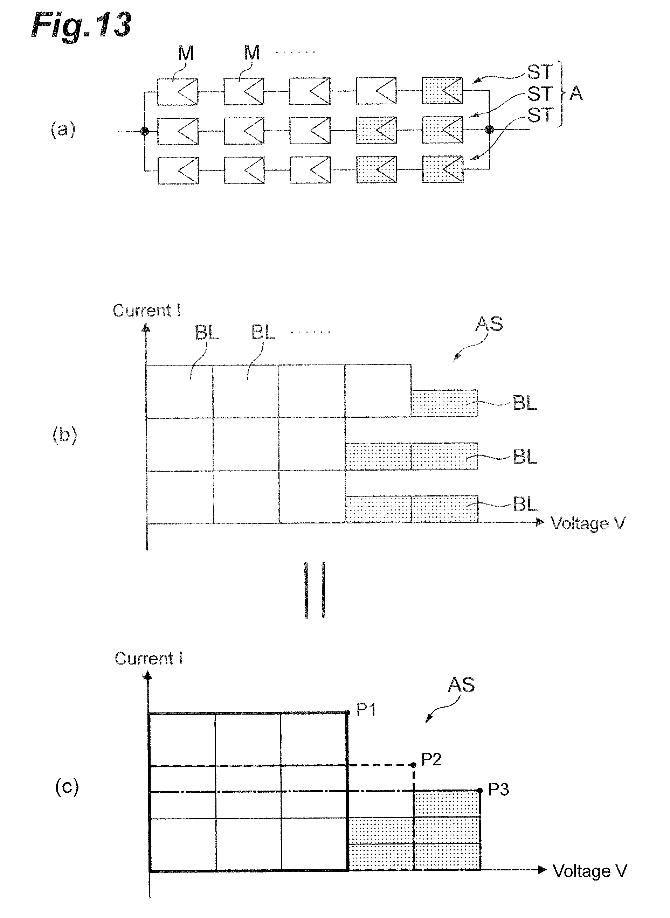

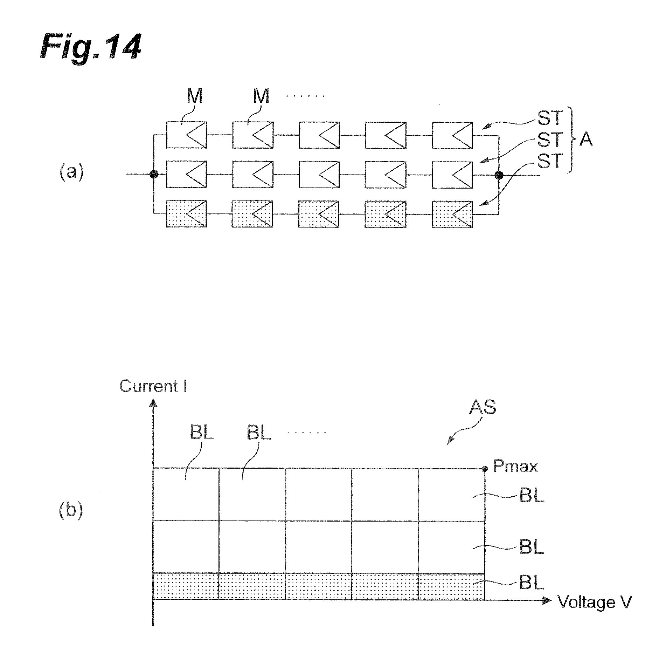

Further, the computation device according to another aspect of the present invention further includes a string formation unit configured to form a string by connecting the photovoltaic modules in series, wherein the class classification unit classifies the photovoltaic modules into at least a first class and a second class of which the photovoltaic modules have parameters lower than that of the first class, the string formation unit forms the strings for each class, and the wire connection pattern selection unit selects the wire connection pattern based on the strings formed by the string formation unit. Accordingly, a string may be formed by only the photovoltaic modules having large parameters, and a string may be formed by only the photovoltaic modules having small parameters. Accordingly, since each of the strings is formed by connecting only the modules having similar parameters in series, it is easy to perform the optimization of the wire connection pattern for each of the classes. Further, a parameter difference (especially, a current difference) between the modules within each of the strings is small, so that it is easy to increase maximum output of an array formed by connecting each of the strings in parallel (e.g. See Figs. 13 and 14).

Further, in the computation device according to another aspect of the present invention, the wire connection pattern selection unit selects the wire connection pattern such that maximum output of an array configured by wire connection of the photovoltaic modules is maximized. Accordingly, a power generation efficiency according to photovoltaic power generation may be improved.

Further, in the computation device according to another aspect of the present invention, the string formation unit forms a first string obtained by connecting only the photovoltaic modules belonging to the first class in series, a second string obtained by connecting only the photovoltaic modules belonging to the second class in series, and a third string obtained by the photovoltaic modules belonging to the first class and the photovoltaic modules belonging to the second class, the third string being formed by connecting a pseudo module formed by connecting the plurality of photovoltaic modules belonging to the second class based on the parameter of the photovoltaic modules belonging to the first class, and the photovoltaic modules belonging to the first class, in series.

In the computation device according to another aspect of the present invention, the first string may be formed by only the photovoltaic modules having large parameters, and the second string may be formed by only the photovoltaic modules having small parameters. Accordingly, since each of the strings is formed by connecting only the modules having similar parameters in series, it is easy to perform the optimization of the wire connection pattern of each of the classes. Further, since the parameter difference (especially, the current difference) between the modules within each of the strings is low, it is easy to increase maximum output of the array formed by connecting the strings in parallel. Further, since the third string, which may obtain a current value equivalent to that of the first string, is formed by using the pseudo modules, all the photovoltaic modules may be used without a waste.

Further, in the computation device according to another aspect of the present invention, the string formation unit connects the photovoltaic modules belonging to the first class in series based on the number of series set for at least the first string, and the third string is formed by supplementing the photovoltaic modules belonging to the first class, of which the number is lower than the number of series, with the pseudo modules. In this way, even when there is a left-over photovoltaic module of which the number is lower than the number of series, in the first class, the left-over photovoltaic modules may be supplemented by the pseudo module, so that the left-over photovoltaic modules are prevented from being useless, so as to contribute to the output of the array.

Further, in the computation device according to another aspect of the present invention, the wire connection selection unit selects a wire connection pattern according to the number of series when maximum output of an array is maximized, among arrays formed by connecting at least one of the first string, the second string, and the third string in parallel, with respect to a plurality of set numbers of series. Candidates of the wire connection patterns of the plurality of patterns may be made by only changing the number of series of the string, and it is sufficient that an optimal number of series is selected among the candidates, so that a computation load may be extremely reduced and a power generation efficiency may be improved.

Further, in the computation device according to another aspect of the present invention, the string formation unit forms the first string and the third string by arranging the photovoltaic modules belonging to the first class in order of a current value, and forms the second string by arranging the photovoltaic modules not used for the third string among the photovoltaic modules belonging to the second class in order of a current value. Since the photovoltaic modules are only arranged in order of the current value, it is easy to form each of the strings. Meanwhile, since the current difference between the photovoltaic modules in each of the strings becomes smaller by arranging the photovoltaic modules in order, it is easy to increase the maximum output of the array.

Further, in the computation device according to another aspect of the present invention, the string formation unit forms a first string obtained by connecting only the photovoltaic modules belonging to the first class in series and a second string obtained by connecting only the photovoltaic modules belonging to the second class in series, and forms the corresponding first string based on maximum output of an array formed by the first string and the corresponding second string based on maximum output of an array formed by the second string.

In the computation device according to another aspect of the present invention, the first string may be formed by only the photovoltaic modules having large parameters, and the second string may be formed by only the photovoltaic modules having small parameters. Accordingly, since each of the strings is formed by connecting only the modules having similar current values in series, it is easy to perform the optimization of the wire connection pattern of each of the classes. Further, since the parameter difference (especially, the current difference) between the modules within each of the strings is low, it is easy to increase maximum output of the array formed by connecting the strings in parallel. Further, since the corresponding first string is formed based on the maximum output of the array formed by the first strings and the corresponding second string is formed based on the maximum output of the array formed by the second string, the wire connection pattern of the array may be independently optimized in each of the classes, and a computation load may be reduced.

Further, in the computation device according to another aspect of the present invention, the string formation unit forms the first string by arranging the photovoltaic modules belonging to the first class in order of a current value, and forms the second string by arranging the photovoltaic modules belonging to the second class in order of a current value. Since the photovoltaic modules are only arranged in order of the current value, it is easy to form each of the strings. Meanwhile, since the current difference between the photovoltaic modules in each of the strings becomes smaller by arranging the photovoltaic modules in order, it is easy to increase the maximum output of the array.

Further, in the computation device according to another aspect of the present invention, the wire connection selection unit may select a wire connection pattern in which all the photovoltaic modules within the same class are connected to each other in series. Accordingly, since the wire connection pattern is instantly determined when the class classification is completed, a computation load may be reduced.

Further, in the computation device according to another aspect of the present invention, for example, a short-circuit current of the photovoltaic module or a current value at a maximum output operation point is used as the current value.

Further, in the computation device according to another aspect of the present invention, the parameter further comprises a voltage value. Accordingly, a change in a voltage value as well as a change in the current value of the photovoltaic modules may be considered, so as to more exactly perform computation.

A photovoltaic power generation system according to an aspect of the present invention includes the above-described computation device and a plurality of photovoltaic modules. Power generation may be effectively performed by using the above-described computation device, and a computation load may be reduced when the wire connection pattern is determined.

In the photovoltaic power generation system according to another aspect of the present invention, the computation device regularly performs acquisition of the parameter, class classification, and selection of the wire connection pattern. Accordingly, the wire connection pattern may be optimally changed according to an environment.

A photovoltaic power generation simulation system sets a wire connection pattern of a plurality of virtually-set photovoltaic modules by the above-described computation device. An optimal wire connection pattern may be determined with a low computation load by using the above-described computation device.

A method of optimizing photovoltaic power generation according to an aspect of the present invention corresponds to a method of optimizing photovoltaic power generation by computing a wire connection pattern of a plurality of photovoltaic modules, and includes acquiring a parameter including at least a current value from each of the photovoltaic modules; performing class classification of the photovoltaic modules based on the acquired parameter; and selecting the wire connection pattern based on the performed class classification.

In the method of optimizing photovoltaic power generation according to an aspect of the present invention, the class classification unit performs the class classification of the photovoltaic modules based on the parameter including at least a current value of each of the photovoltaic modules. That is, since the optimization of the wire connection pattern of each of the classes may be performed by performing the class classification even when the number of the photovoltaic modules increases, a computation load is reduced as compared with a case of performing computation after organizing the wire connection pattern of the plurality of photovoltaic modules. Accordingly, the wire connection pattern is effectively selected, so that the power generation performance of the photovoltaic power generation is improved while the computation load is reduced.

### Advantageous Effects of Invention

The present invention can improve a power generation performance while reducing a computation load by effectively selecting a wire connection pattern.

### Brief Description of Drawings

Fig. 1 is a block diagram illustrating a configuration of a photovoltaic power generation system according to a first embodiment of the present invention;
Fig. 2 is a flowchart illustrating processing of a computation device according to a first embodiment of the present invention;
Fig. 3 is a flowchart illustrating processing of a computation device according to a first embodiment of the present invention;
Fig. 4 is a flowchart illustrating processing of a computation device according to a first embodiment of the present invention;
Fig. 5 is a flowchart illustrating processing of a computation device according to a first embodiment of the present invention;
Fig. 6 is a flowchart illustrating processing of a computation device according to a first embodiment of the present invention;
Fig. 7 is a flowchart illustrating processing of a computation device according to a first embodiment of the present invention;
Fig. 8 is a concept view for describing processing of a computation device according to a first embodiment of the present invention;
Fig. 9 is a concept view for describing processing of a computation device according to a first embodiment of the present invention;
Fig. 10 is a concept view for describing processing of a computation device according to a first embodiment of the present invention;
Fig. 11 is a concept view for describing processing of a computation device according to a first embodiment of the present invention;
Fig. 12 is a concept view for describing a basic concept of a computation device of the present invention;
Fig. 13 is a concept view for describing a basic concept of a computation device of the present invention;
Fig. 14 is a concept view for describing a basic concept of a computation device of the present invention;
Fig. 15 is a block diagram illustrating a configuration of a photovoltaic power generation system according to a second embodiment of the present invention;
Fig. 16 is a flowchart illustrating processing of a computation device according to a second embodiment of the present invention;
Fig. 17 is a flowchart illustrating processing of a computation device according to a second embodiment of the present invention;
Fig. 18 is a flowchart illustrating processing of a computation device according to a second embodiment of the present invention;
Fig. 19 is a flowchart illustrating processing of a computation device according to a second embodiment of the present invention;
Fig. 20 is a flowchart illustrating processing of a computation device according to a second embodiment of the present invention;
Fig. 21 is a concept view for describing processing of a computation device according to a second embodiment of the present invention;
Fig. 22 is a concept view for describing processing of a computation device according to a second embodiment of the present invention;
Fig. 23 is a concept view for describing processing of a computation device according to a second embodiment of the present invention;
Fig. 24 is a block diagram illustrating a configuration of a photovoltaic power generation system according to a third embodiment of the present invention;
Fig. 25 is a flowchart illustrating processing of a computation device according to a third embodiment of the present invention;
Fig. 26 is a flowchart illustrating processing of a computation device according to a third embodiment of the present invention;
Fig. 27 is a flowchart illustrating processing of a computation device according to a third embodiment of the present invention;
Fig. 28 is a flowchart illustrating processing of a computation device according to a third embodiment of the present invention;
Fig. 29 is a concept view for describing processing of a computation device according to a third embodiment of the present invention;
Fig. 30 is a concept view for describing processing of a computation device according to a third embodiment of the present invention; and
Fig. 31 is a flowchart illustrating processing of a computation device according to a modified embodiment.

### Description of Embodiments

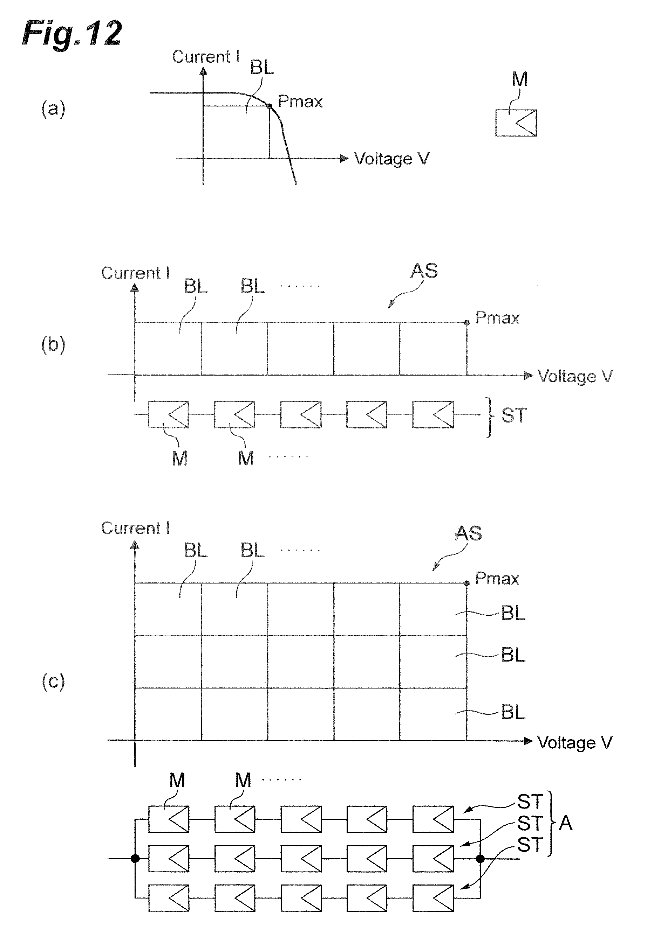

First, a basic concept of the present invention will be described. First, when a relation between a current and a voltage of a photovoltaic module M is expressed by a graph, an IV curve is drawn as illustrated in Fig. 12. A maximum output operation point Pmax where an output of the photovoltaic module M is maximized is set for the IV curve. At this time, when a rectangle is set for the maximum output operation point Pmax, a relation in which "an area of the rectangle is equal to a maximum output of the photovoltaic module M" is established. Thus, it is possible to simplify subsequent computation by approximating the IV curve to the rectangle. The approximated rectangle as described above is referred to as "an output block BL" in the following description for description. When the output block BL approximated as described above is used, a relation between a current and a voltage of a string in which a plurality of photovoltaic modules M are connected to each other in series and of which a voltage increases is illustrated as Fig. 12B. An aggregation of the output blocks BL formed by coupling of the photovoltaic modules M is referred to as "an output assembly AS" in the following description. The output assembly AS corresponding to the string ST in which the photovoltaic modules M are connected to each other in series is configured by stacking each of the output blocks BL in a transverse direction. A maximum output operation point Pmax for the string ST is set at an upper right corner of the output assembly AS. A relation between a current and a voltage of an array A in which the strings ST are connected to each other in parallel and of which a current increases is illustrated as Fig. 12C. The output assembly AS corresponding to the array A is configured by stacking a stage of the output block BL corresponding to each of the strings ST several times. A maximum output operation point Pmax for the array A is set at an upper right corner of the output assembly AS.

When all forms of the output blocks are equal to each other as illustrated in Fig. 12C, the output assembly AS corresponding to the array A becomes a simple rectangle, so that the maximum output operation point Pmax may be easily set. However, as illustrated in Fig. 13A, some of the photovoltaic modules M may become shaded. In this case, a current is lowered by an amount corresponding to the number of the photovoltaic modules M which become shaded, so that there is a possibility that the output block BL is lowered, and a voltage is lowered, so that there is a possibility that the output block BL is narrowed. In this case, as illustrated in an upper end of the Fig. 13B, the output blocks BL corresponding to the photovoltaic modules M in shaded portions become smaller (herein, only the current becomes smaller). Since each of the output blocks BL becomes smaller so that a space therebetween is opened, the output assembly AS is reconstructed to fill the corresponding space, and is configured as illustrated in a lower end of Fig. 13B. The maximum output operation point Pmax for the output assembly AS deformed as described above cannot be univocally determined, and is set as any one of candidate points P1, P2, and P3. However, when the candidate point P1 is set as the maximum output operation point Pmax, only electric power within a range of a rectangle drawn by a solid line is used, and electric power within the other ranges becomes useless. When the candidate point P2 is set as the maximum output operation point Pmax, only electric power within a range of a rectangle drawn by a dotted line is used, and electric power within the other ranges becomes useless. When the candidate point P3 is set as the maximum output operation point Pmax, only electric power within a range of a rectangle drawn by an alternated long and short dash line is used, and electric power within the other ranges becomes useless.

Here, optimization of connection of the photovoltaic modules M is desired, and a string ST is configured only by the photovoltaic modules M which becomes shaded, as illustrated in Fig. 14A. Further, the array A is formed not by physically moving locations of the photovoltaic modules M but by changing only wire connections between the photovoltaic modules M. In this case, as illustrated in Fig. 14B, a first stage of the output assembly AS is configured only by the output block BL corresponding to the string ST which becomes shaded, and all of heights (electric power) of the output blocks BL are equal to each other. Thus, when viewed as a whole, the output assembly AS is drawn as a rectangle. Such an output assembly AS may univocally set a maximum output operation point Pmax, so that a part of electric power does not become useless, and all of electric power contributes to the maximum output. As described above, improvement of an amount of the power generation is desired by optimizing a connection relation between the photovoltaic modules M. Here, when the number of the photovoltaic modules M is large, an amount of computation increases enormously. In the computation device which optimizes photovoltaic power generation, the method which optimizes photovoltaic power generation, the photovoltaic power generation system, and the photovoltaic power generation simulation system according to embodiments of the present invention, it is possible to improve the power generation amount through a small amount of computation, by performing class classification of the photovoltaic modules M.

### [First embodiment]

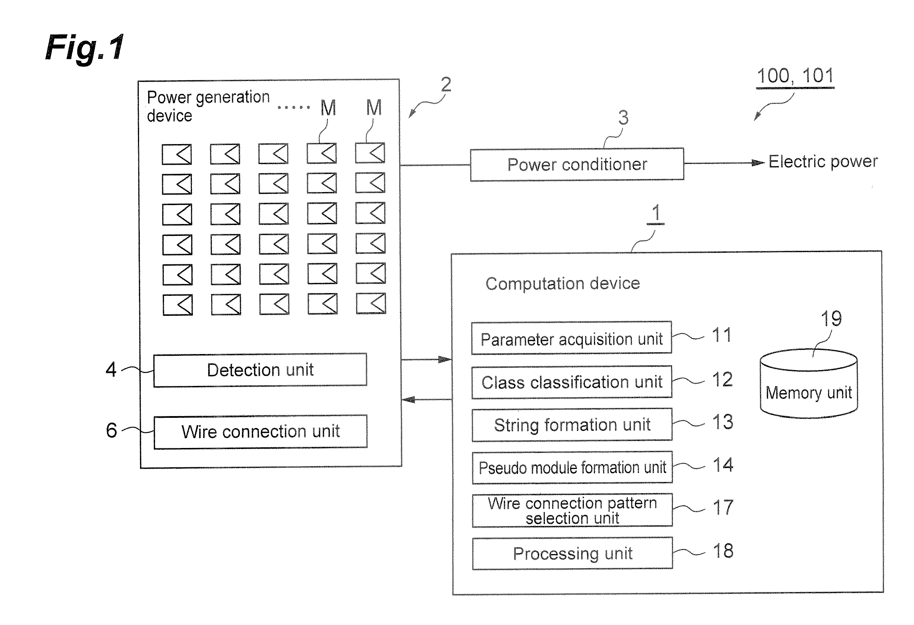

A computation device which optimizes photovoltaic power generation, a photovoltaic power generation system, and a method which optimizes photovoltaic power generation according to a first embodiment of the present invention will be described in detail with reference to Fig. 1.

As illustrated in Fig. 1, the photovoltaic power generation system 100 includes a computation device 1, a power generation device 2, and a power conditioner 3.

The power generation device 2 has a function of generating electric power by sunlight, and includes a plurality of photovoltaic modules M, a detection unit 4, and a wire connection unit 6. The photovoltaic modules M are arranged in a plane direction in a plurality of vertical rows and horizontal rows, respectively, and are separated from each other by a space. Further, the physical arrangement of the photovoltaic modules M is fixed. The detection unit 4 may detect all parameters of the photovoltaic modules M. The detection unit 4 may detect a current value and a voltage value as parameters. The detection unit 4 detects at least the current value. In detail, the detection unit 4 is configured by detection sensors which are installed in the photovoltaic modules M, respectively. The detection unit 4 has a function of outputting the detection result to the computation device 1. The wire connection unit 6 has a function of connecting the photovoltaic modules M based on a wire connection pattern selected by the computation device 1. The wire connection unit 6 may connect the plurality of photovoltaic modules M in all patterns regardless of a physical location. The wire connection unit 6 may connect the photovoltaic modules M, which are not adjacent to each other, in series and in parallel.

The power conditioner 3 has a function of converting DC electric power generated by the power generation device 2, and includes an DC/DC convertor. In the present embodiment, it is sufficient that one power conditioner 3 is installed for the power generation device 2 (i.e. for an array A of the photovoltaic modules M).

The computation device 1 simultaneously has a function of optimizing the photovoltaic power generation and a function of performing a control of the whole photovoltaic power generation system 100, and for example, is configured by a device (e.g. a device including a Central Processing Unit (CPU), a Read Only Memory (ROM), a Random Access Memory (RAM), and an input and output interface) which performs an electronic control. The computation device 1 has a function of computing and selecting an optimal wire connection pattern of the plurality of photovoltaic modules M. The computation device 1 has a function of transmitting/receiving a signal to/from the power generation device 2. The transmission/reception of the signal may be performed by wireless communication or wired communication. The computation device 1 includes a parameter acquisition unit 11, a class classification unit 12, a string formation unit 13, a pseudo module formation unit 14, a wire connection pattern selection unit 17, a processing unit 18, and a memory unit 19.

The parameter acquisition unit 11 has a function of acquiring a parameter including at least a current value and a voltage value from each of the photovoltaic modules M by receiving output of the detection unit 4.

The class classification unit 12 has a function of classifying a class of each of the photovoltaic modules M based on the parameter. Further, the class classification unit 12 has a function of classifying the photovoltaic modules M which have similar parameters into the same class, and more specifically, into a class of which the current value is high and a class of which the current value is low. In the present embodiment, although the photovoltaic modules M are classified into two classes including a sunny class and a shaded class which has a lower voltage than that of the corresponding sunny class, the photovoltaic modules may be classified into more classes. Meanwhile, in the class classification, the number of classes may be previously limited, and the number of the photovoltaic modules M within the classes may be previously limited. Accordingly, the number of the photovoltaic modules M included in the classes may be set to be within a predetermined range, and a computation load may decrease.

The string formation unit 13 has a function of forming a string ST of the photovoltaic modules M for each of the classes. The string formation unit 13 may form a string ST (a first string) of the sunny class obtained by connecting only the photovoltaic modules M belonging to the sunny class in series, a string ST (a second string) of the shaded class obtained by connecting only the photovoltaic modules M belonging to the shaded class in series, a string ST (a third string) obtained by connecting left-over modules EM of the photovoltaic modules belonging to the sunny class and pseudo modules VM configured by the photovoltaic modules M belonging to the shaded class in series. Further, the string formation unit 13 may form all of the three types of the strings ST, only two types of the strings among the three types of the strings, or only one type of the strings among the three types of the strings, according to the number of the photovoltaic modules M within each of the classes. The string formation unit 13 connects the photovoltaic modules M belonging to the sunny class and the shaded class in series based on the set number of series, and forms a string ST including the left-over modules EM by supplementing the left-over modules EM of which the number is lower than the number of series with the pseudo modules VM. The number of series may be set to be the numbers (e.g. from 5 to 7) within a predetermined range by an allowance voltage of the power conditioner 3, etc., and the string formation unit 13 may form the string ST according to each of the numbers of series. Further, the string formation unit 13 has a function of forming each of the strings ST by arranging the photovoltaic modules M belonging to the sunny class in order of the current values, and forming the string ST by arranging the photovoltaic modules M, which are not used as the pseudo modules VM, among the photovoltaic modules M belonging to the shaded class in order of the current values.

The pseudo module formation unit 14 has a function of forming the pseudo module VM by connecting the plurality of photovoltaic modules M belonging to the shaded class in parallel based on a parameter (in the present embodiment, a current value) of the photovoltaic modules M belonging to the sunny class.

The wire connection pattern selection unit 17 has a function of selecting a wire connection pattern based on the class classification and a function of selecting a wire connection pattern to maximize maximum output of the array A configured by the wire connection of the photovoltaic modules M.

The processing unit 18 has a function of performing a process other than the process performed in each of the above-mentioned units 11 to 17. The memory unit 19 has a function of storing various information.

In the class classification, a maximum output operation current of the photovoltaic circuit under a predetermined condition, e.g. a cell temperature 25°C, a solar radiation intensity 1 kW/m2, and a spectrum AM 1.5 may be used, and a short-circuit current under the same predetermined condition may be used. Further, a current value under another condition, e.g. a Nominal Operating Cell Temperature (NOCT), may be used. Further, when installation angles of the photovoltaic circuits are different from each other according to the modules, or when effects of the shade generated in the modules are different from each other according to the modules, it is possible that an anticipation value of a current of each module is obtained in advance by computation for a predetermined singular date and time or predetermined plural dates and times to optimize the wire connection between the photovoltaic modules by the result. Further, it is possible that the class classification is performed plural times according to the date and time, optimal wire connection for each case is obtained and stored, and the wire connection is changed according to the date and time. In this case, the optimal wire connection pattern changed according to the date and time may be minutely realized, so as to obtain a power generation amount improvement effect which is more excellent than that of a case where optimization is performed only at a time of installation work. Further, it is possible that the maximum output operation current or the short-circuit current is actually and regularly measured to regularly perform the class classification and the optimization of the wire connection pattern of the photovoltaic modules M, based on the result. In this case, an actual parameter is used, so as to obtain a more excellent power generation amount improvement effect.

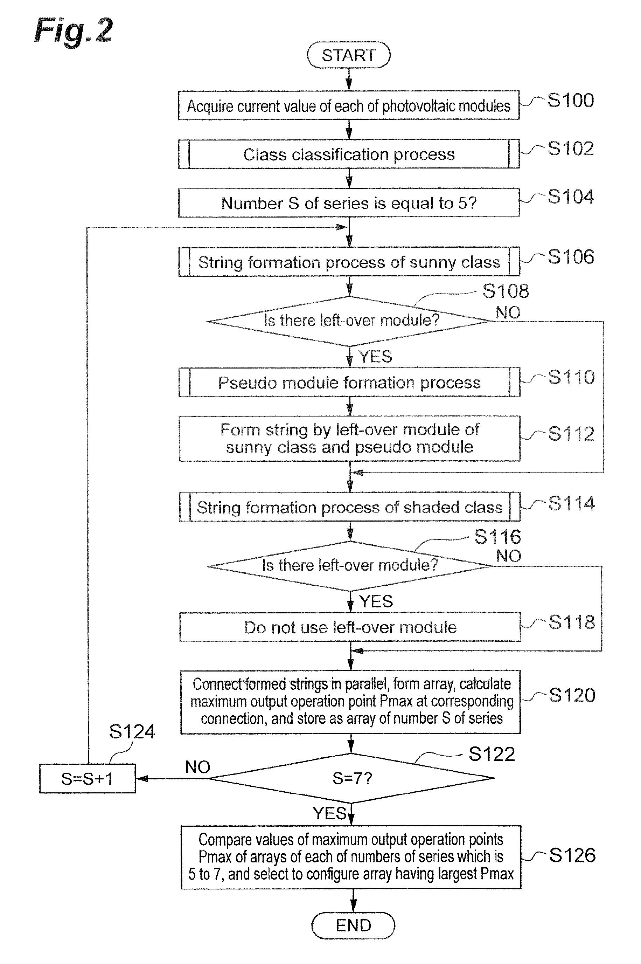

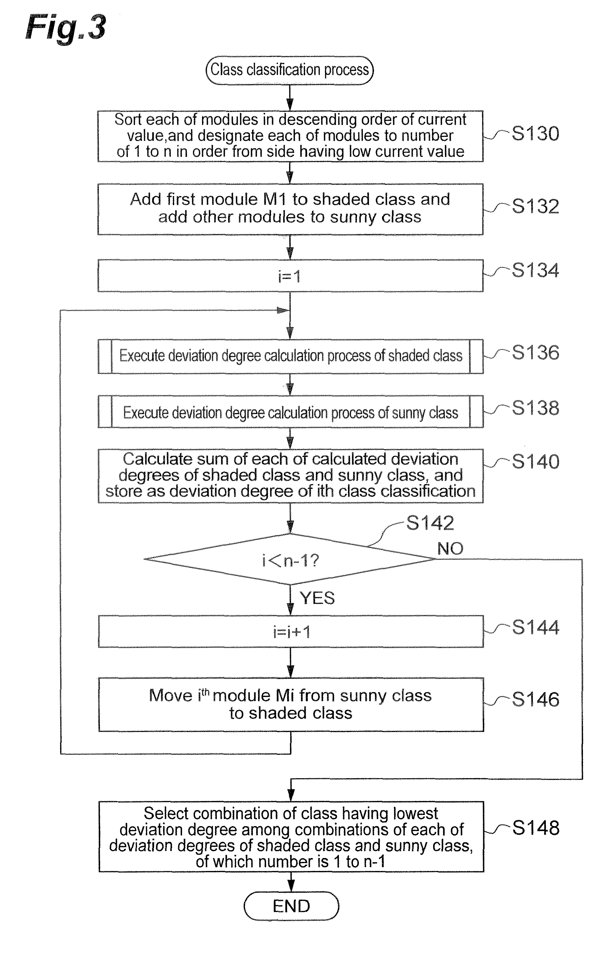

Next, a computation process of the computation device 1 will be described in detail with reference to Figs. 2 to 11. Fig. 2 is a flowchart illustrating processing executed when the computation device 1 selects an optimal wire connection pattern of the photovoltaic module. The process of Fig. 2 is executed at a predetermined timing of selecting the wire connection pattern. Figs. 3 to 7 are flowcharts illustrating the processes of the Fig. 2 in detail, respectively.

In an output of the photovoltaic modules M according to being shaded, a change in a voltage is smaller than a change in a current. In a control process according the present embodiment, computation is performed by approximating that the voltage of the photovoltaic modules M in shade is not changed but only the current thereof is changed. As illustrated in Fig. 2, the parameter acquisition unit 11 acquires a current value of each of the photovoltaic modules M (step S100). A short-circuit current or a current value of a maximum output operation point of the photovoltaic module M may be used as the current value. Next, the class classification unit 12 executes a class classification process of each of the photovoltaic modules M based on the current value acquired in step S100 (step S102). The class classification unit 12 classifies the plurality of photovoltaic modules M into "a sunny class" and "a shaded class". The shaded class is a class having a current value lower than that of the sunny class.

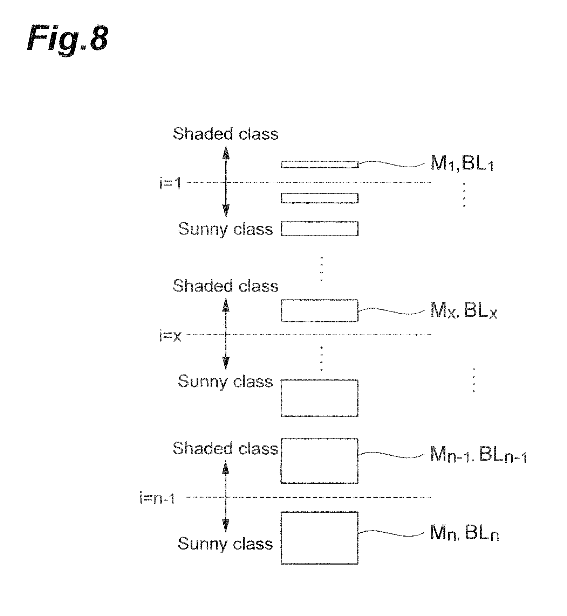

Here, a process of the class classification of step S102 will be described in detail with reference to Fig. 3. In Fig. 3, the class classification unit 12 provisionally classifies the photovoltaic modules into "the sunny class" and "the shaded class" as all the patterns to obtain an optimal pattern, and adopts the corresponding combination as the class classification. First, the class classification unit 12 sorts the photovoltaic modules M in descending order of the current values of the photovoltaic modules M, and designates the photovoltaic modules M numbers of 1 to n in order from a photovoltaic module of which the current value is low, respectively (step S130). In detail, as illustrated in Fig. 8, the photovoltaic modules M are designated by the numbers of M₁, M₂, ..., Mᵢ, .... Mₙ in order from a photovoltaic module of which the current value is low (in order from an output block BL of which the height is low) and then are arranged. Meanwhile, in Fig. 8, the photovoltaic modules M are illustrated while being substituted for the output blocks BL, in order to be easily understood. That is, the photovoltaic modules M which become shaded are illustrated as being thin since currents thereof decrease so that the heights of the output blocks BL are lowered. The same effect may be applied to the following drawings.

Next, the class classification unit 12 adds a first photovoltaic module M1 having the lowest current value to the shaded class, and adds other photovoltaic modules M₂ to Mₙ to the sunny class (step S132). Further, the class classification unit 12 sets "1" as a pattern number i (step S 134).

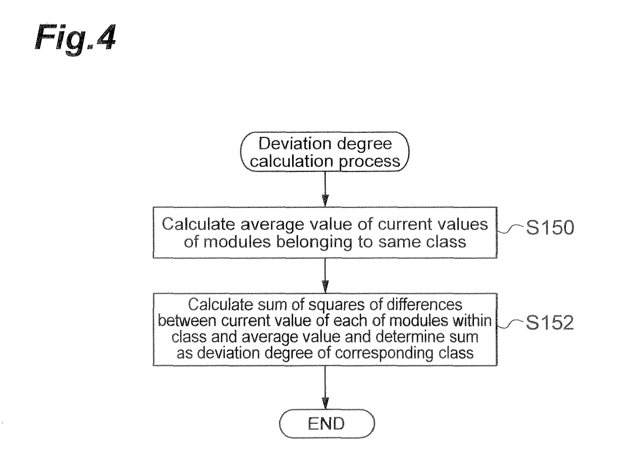

Next, the class classification unit 12 executes a deviation calculation process of each of the classes (steps 5136 and S138). As illustrated in Fig. 4, in the detailed computation of the deviation, the class classification unit 12 computes an average value of the current values of the photovoltaic modules M belonging to the same class (step S150). Next, the class classification unit 12 calculates a squaring value of a difference between the average value of the current values and the current value of each of the photovoltaic modules M within the class, and calculates the sum of the corresponding squaring value for all the photovoltaic modules M. The class classification unit 12 sets the summed value of the squaring values as a deviation degree of the class in the pattern number i (step S152). In a method illustrated in Fig. 4, the class classification unit 12 calculates a deviation degree of the shaded class (step S136), and calculates a deviation degree of the sunny class (step S138). Next, the class classification unit 12 calculates the sum of the deviation degree of the shaded class calculated in step S136 and the deviation degree of the sunny class calculated in step S138, sets the sum value as a class classification deviation degree in the pattern number i, and stores the sum value in the memory unit 19 (step S 140).

Next, the class classification unit 12 determines whether the pattern number reaches n-1 (step S142). In step S142, when it is determined that the pattern number i does not reach n-1, that is, when there remains a pattern in which the class classification deviation degree is not calculated, the class classification unit 12 adds 1 to the pattern number i (step S144). The class classification unit 12 moves an ith photovoltaic module Mi in the newly-set pattern number i (i.e. a photovoltaic module having the lowest current value among the photovoltaic modules classified into the sunny class in the previous computation) from the sunny class to the shaded class (step S146). Thereafter, the class classification unit 12 repeatedly executes the process of S 136 to S 146 until calculating a class classification deviation degree of a pattern number i where i is equal to n-1. Accordingly, all the class classification deviation degrees of the pattern numbers i where i corresponds to 1 to n-1, respectively, are calculated.

When the class classification deviation degree of the pattern number i, where i is equal to n-1, is calculated, it is determined in step S 142 that the pattern number i reaches n-1, and the process proceeds to step S148. The class classification unit 12 selects a pattern having the lowest class classification deviation degree among combinations of the classes of the pattern number i, where i corresponds to 1 to n-1 (step S 148). Accordingly, the process of the class classification of the sunny class and the shaded class is completed, and the process illustrated in Fig. 3 is terminated.

Referring back to Fig. 2, the processing unit 18 sets the lowest value among preset numbers of series as the number S of series (step S104). The number S of series corresponds to the number of series of the string ST when the array A of the photovoltaic modules M is configured, and is determined by a voltage value which the power conditioner 3 allows. When the number of series is too high, the voltage value becomes too high, so that the power conditioner 3 is damaged, and when the number of series is too small, the voltage value becomes too small, so that the power conditioner 3 may not be operated. In the present embodiment, the number of series is set to be 5 to 7. Thus, in step S104, the number of series is set to be 5. Next, the string formation unit 13 executes a process of forming a string of the sunny class (step S106). Further, in the following description, the photovoltaic modules M of the sunny class (the output blocks BL thereof) are described as "photovoltaic modules M_{S} (output blocks BL_{S})" and the photovoltaic modules M of the shaded class (the output blocks BL thereof) are described as "photovoltaic modules M_{D} (output blocks BL_{D})".

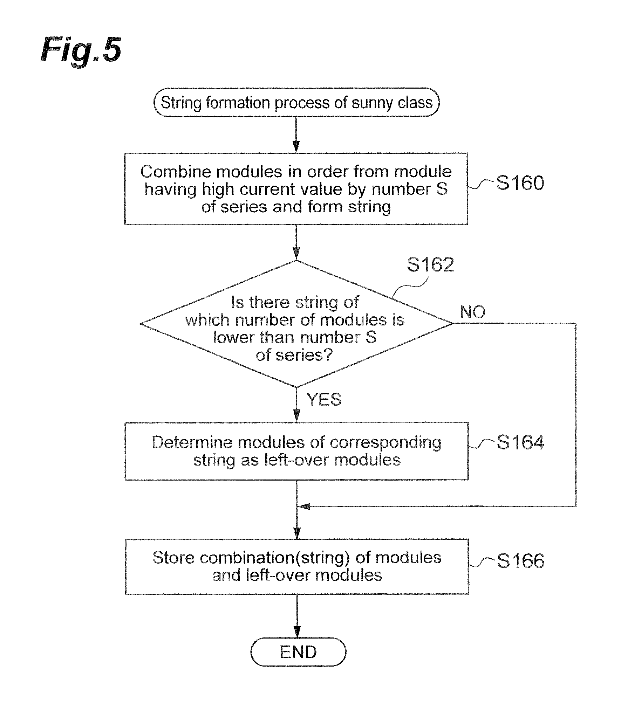

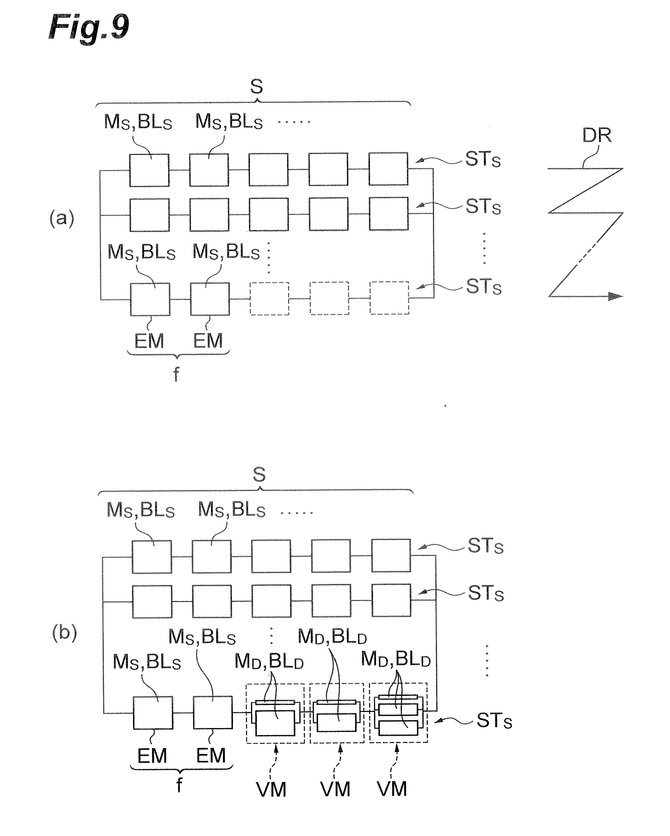

Here, a process of forming a string of the sunny class will be described in detail with reference to Fig. 5. As illustrated in Fig. 5, the string formation unit 13 combines the photovoltaic modules M_{S} of the sunny class in order from a photovoltaic module of which the current value is high by the number S of series, and forms a sunny string ST_{S} (step S160). For example, as illustrated in Fig. 9A, the photovoltaic modules M_{S} are arranged in order indicated by DR in the drawing from a photovoltaic module of which the current value is high. The sunny string ST_{S} of which the number of the photovoltaic modules M_{S} is equal to the number S of series is formed, and the sunny strings are connected to each other in parallel. Further, in Fig. 9, strictly, heights of the photovoltaic modules M_{S} (output blocks BL_{S}) are lowered slowly. However, the photovoltaic modules M_{S} have the same shape in order to be distinguished from "the photovoltaic module M_{D} (output block BL_{D})" described below.

Next, the string formation unit 13 determines whether there is a sunny string ST_{S} of which the number of the photovoltaic modules M_{S} is lower than the number S of series (step S162). In an example of in Fig. 9, the bottom sunny string ST_{S} lacks three photovoltaic modules M_{S}. When it is determined in step S162 that there is a sunny string ST_{S} of which the number of the photovoltaic modules M_{S} is lower than the number S of series, the string formation unit 13 sets the photovoltaic modules M_{S} of the corresponding sunny string ST_{S} as f "left-over modules EM" (step S164). Thereafter, the string formation unit 13 stores the set sunny string ST_{S} and the left-over modules EM in the memory unit 19 (step S166). Meanwhile, when it is determined in step S 162 that there are no sunny strings ST_{S} of which the number of the photovoltaic modules M_{S} is lower than the number of series, the string formation unit 13 stores the set sunny string ST_{S} in the memory unit 19 (step S 166).

Referring back to Fig. 2, the processing unit 18 determines whether there is a left-over module EM (step S108). In detail, the processing unit 18 determines whether there is a reminder module EM, based on information stored in the memory unit 19 in step S166 of Fig. 5. When it is determined in step S108 that there are no left-over modules EM, the computation process proceeds to a process of forming a string of a shaded class (step S114). Meanwhile, when it is determined in step S166 that there are left-over modules EM, the pseudo module formation unit 14 executes a pseudo module formation process (step S110). The pseudo module formation unit 14 supplements the deficient photovoltaic modules M_{S} by adding a module (hereinafter, referred to as a pseudo module VM) artificially formed by the photovoltaic modules M_{D} of the shaded class to the sunny string ST_{S} having the left-over module EM.

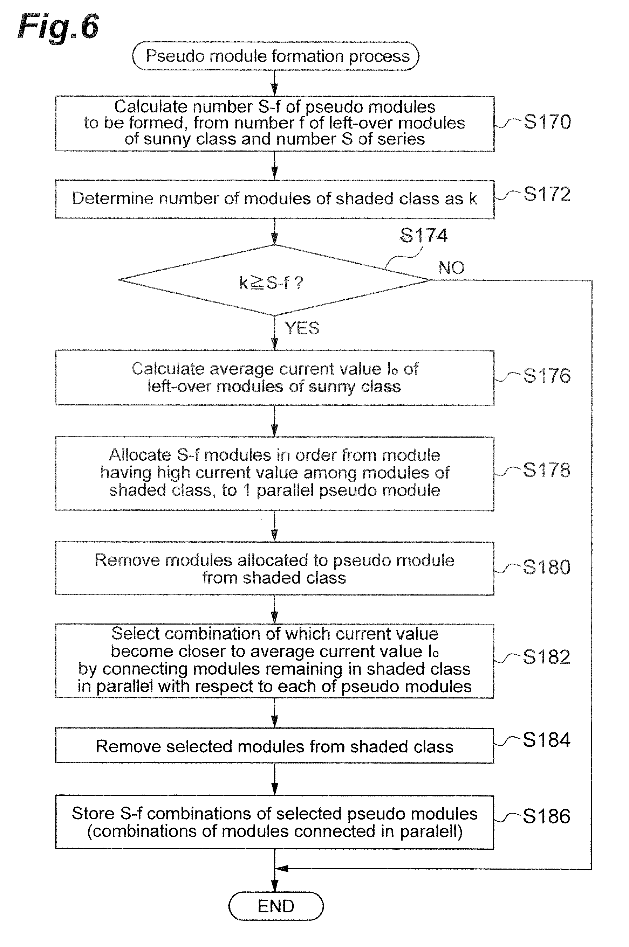

Here, a process of forming a pseudo module will be described in detail with reference to Fig. 6. First, the pseudo module formation unit 14 computes the number S-f of the pseudo modules to be formed, based on the number f of the left-over modules EM of the sunny string ST_{S} and the number S of series (step S170). In an example of Fig. 9, since the number f of the left-over modules EM is equal to 2, and the number S of series is equal to 5, the number of the pseudo modules VM is calculated as 3.

Next, the pseudo module formation unit 14 determines whether to cover the needed number of the pseudo modules VM by the number of the photovoltaic modules M_{D} classified into the shaded class. In detail, the pseudo module formation unit 14 determines that the number of the photovoltaic modules M_{D} classified into the shaded class is k (step S172), and determines whether the corresponding number of the modules is equal to or larger than the number S-f of the pseudo modules (step S 174). When it is determined in step S 174 that the number S-f of the pseudo modules is larger than the number k of the photovoltaic modules M_{D} of the shaded class, the pseudo modules VM cannot be made, so that the pseudo module VM is not formed and the process of Fig. 6 is terminated.

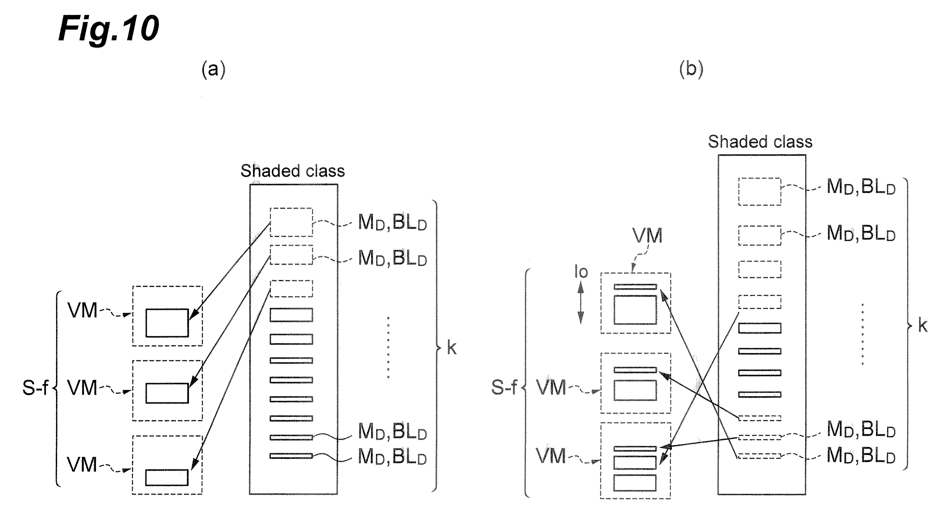

Meanwhile, when it is determined in step S174 that the number k of the photovoltaic modules M_{D} is larger than the number S-f of the pseudo modules, the pseudo module formation unit 14 calculates an average current value I0 of the left-over modules EM of the sunny class (step S176). The corresponding average current value 10 is set as a target current value when the pseudo modules VM are formed. The pseudo module formation unit 14 allocates S-f photovoltaic modules M_{D} to a parallel pseudo module VM in order from the photovoltaic modules M_{D} of which the current value is high among the photovoltaic modules M_{D} of the shaded class (step S178). Further, the pseudo module formation unit 14 removes the allocated photovoltaic modules M_{D} from the shaded class (step S180). In an example of Fig. 10A, the photovoltaic modules M_{D} are allocated to three pseudo modules VM one by one in order from a photovoltaic module M_{D} of which the current value is high. The allocation order at this time also follows the order indicated by DR illustrated in Fig. 9A. Further, the three allocated photovoltaic modules M_{D} are removed from the shaded class.

Next, the pseudo module formation unit 14 allocates the photovoltaic modules M_{D} remaining in the shaded class and connects the allocated photovoltaic modules M_{D} to each other in parallel, with respect to each of the pseudo modules VM. Accordingly, the pseudo module formation unit 14 selects a combination of which the current value becomes closer to the average current value I0, with respect to each of the pseudo modules VM. The pseudo module formation unit 14 removes the selected photovoltaic modules M_{D} from the shaded class (step S 184). Further, the pseudo module formation unit 14 stores the selected S-f group of the pseudo modules VM (combinations of the photovoltaic modules M_{D} connected in parallel) in the memory unit 19 (step S 186). In an example of Fig. 10B, the photovoltaic modules M_{D} are selected among the photovoltaic modules M_{D} of which the current value is low in order to supplement the current value of the photovoltaic modules M_{D} already allocated to the pseudo modules VM and are allocated to the pseudo modules VM. Further, the allocated photovoltaic modules M_{D} are connected to each other in parallel within each of the pseudo modules VM. When the process of step S 186 is completed, the formation process of the pseudo modules VM is terminated and the process of Fig. 6 is terminated.

Referring back to Fig. 2, the string formation unit 13 forms the string ST_{S} by the left-over module EM of the sunny class and the pseudo modules VM formed in step S110 (step S112). In detail, as illustrated in Fig. 9B, the string formation unit 13 connects the photovoltaic modules M_{D} within each of the pseudo modules VM in parallel and connects the left-over modules EM and the pseudo modules VM in series, so as to form one sunny string ST_{S}. Next, the string formation unit 13 executes a process of forming a string of the shaded class, which forms a string ST_{D} of the shaded class (step S114).

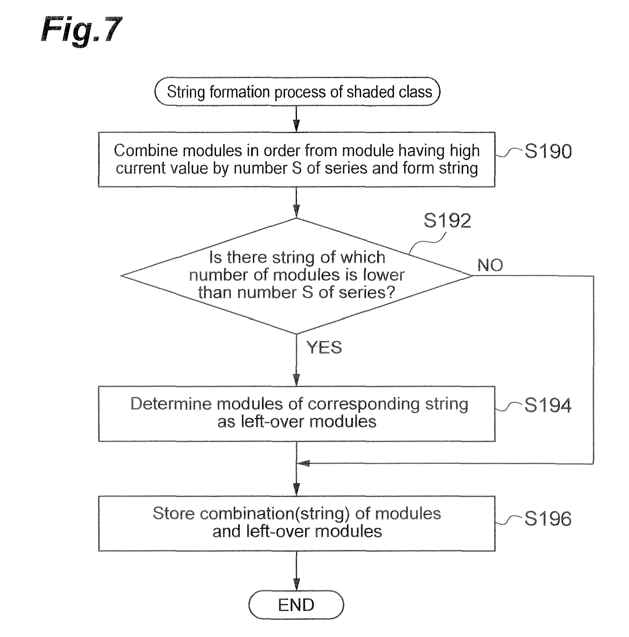

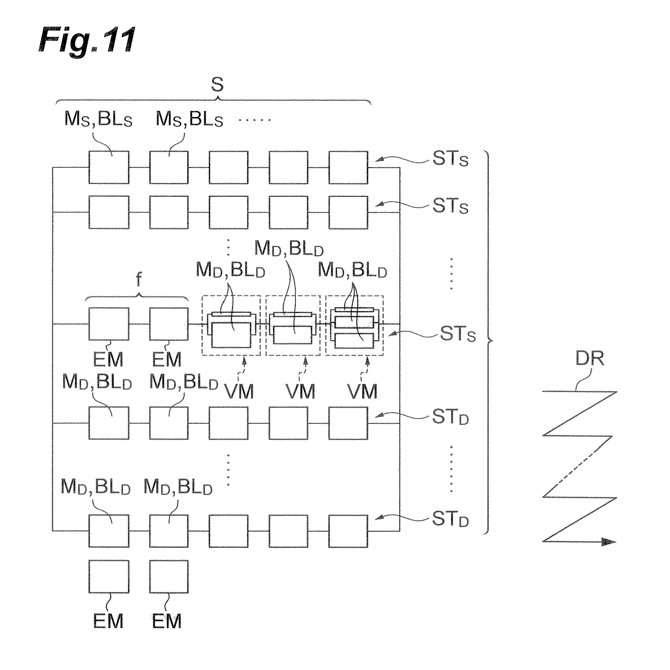

Here, a process of forming a string of the shaded class will be described in detail with reference to Fig. 7. Further, when the photovoltaic modules M_{D} are used for making the pseudo modules VM in the process of Fig. 6 for forming a pseudo module, the process of Fig. 7 is executed in a state in which the used photovoltaic modules M_{D} are removed from the shaded class. First, the string formation unit 13 combines the photovoltaic modules M_{D} within the shaded class by the number S of series in order from a photovoltaic module of which the current value is high, and forms a string ST_{D} (step S190). In an example of Fig. 11, the photovoltaic modules M_{D} are arranged in order from a photovoltaic module of which the current value is high according to a direction indicated by DR in the drawing. Next, the string formation unit 13 determines whether there is a string ST_{D} of which the number of the modules is lower than the number S of series (step S 192). When it is determined in step S 192 that there is a string ST_{D} of which the number of the modules is lower than the number S of series, the string formation unit 13 determines the photovoltaic modules M_{D} of the corresponding string ST_{D} as the left-over modules EM (step S194). Meanwhile, when it is determined in step S 192 that there are no strings ST_{D} of which the number of the modules is lower than the number S of series, there are no left-over modules EM so that step S 194 is skipped. The string formation unit 13 stores a combination (string ST_{D}) of the photovoltaic modules M_{D} of the shaded class, and the left-over modules EM (step S196). When the process of step S196 is completed, the process of forming the string of the shaded class is terminated, and the process of Fig. 7 is terminated.

Referring back to Fig. 2, the processing unit 18 determines whether there are left-over modules EM of the shaded class (step S116). In detail, the processing unit 18 determines whether there is a reminder module EM of the shaded class, based on information stored in the memory unit 19 in step S 196 of Fig. 7. When it is determined in step S 116 that there are left-over modules EM, the processing unit 18 determines not to use the corresponding left-over modules EM (step S 118). When it is determined in step S 116 that there are no left-over modules EM, the process of step S 118 is skipped.

Next, the string formation unit 13 connects the string ST_{S} of the sunny class and the string ST_{D} of the shaded class, which are formed in steps S110, S 112, and S 114, in parallel, to form an array A. Further, the string formation unit 13 calculates a maximum output operation point Pmax at the corresponding array A, and stores the array A of the number S of series in the memory unit 19 (step S120). For example, in an example of Fig. 11, the string formation unit 13 connects the string ST_{S} of the sunny class and the string ST_{D} of the shaded class in parallel, so as to form an array A. At this time, the left-over modules EM of the shaded class are not used. Further, the string formation unit 13 makes an output assembly AS having a shape illustrated in Fig. 14B by using output blocks BL of the made array A, to determine the maximum output operation point Pmax.

Next, the processing unit 18 determines whether the number S of series is 7 (step S122). When it is determined that the number S of series is not 7 (i.e. 5 or 6), the processing unit 18 adds 1 to the number S of series (step S124). Further, in the newly-set number S of series, the processes of step S106 to step S122 are repeatedly performed. Accordingly, the maximum output operation point Pmax at the array A when the number of series is added by 1 may be calculated.

When it is determined in step S122 that the number S of series is 7, it is determined that array formation for all the numbers of series is terminated, and the wire connection pattern selection unit 17 selects a configuration of the array A in a case where the Pmax has the highest value, by reading out, from the memory unit 19, the maximum output operation points Pmax of the arrays A when the number S of series is 5 to 7 and comparing the read-out maximum output operation points Pmax at the same time (step S126). That is, the wire connection pattern selection unit 17 selects a wire connection pattern which may constitute the corresponding array A. When the process of step S126 is terminated, the wire connection pattern to be adopted is determined, and the process of Fig. 2 is terminated.

Next, the operation and the effect of the present embodiment will be described.

By the computation device 1, the class classification unit 12 performs the class classification of the photovoltaic modules M based on the parameter including the current value of each of the photovoltaic modules M. That is, since the optimization of the wire connection pattern of each of the classes may be performed by performing the class classification even when the number of the photovoltaic modules M increases, a computation load is reduced as compared with a case of performing computation after organizing the wire connection pattern of the plurality of photovoltaic modules. Accordingly, the wire connection pattern is effectively selected, so that the power generation performance is improved while the computation load is reduced.

Further, the class classification unit 12 classifies the photovoltaic modules M of which the parameters have similar values into the same class. Accordingly, the string ST and the array A may be configured by using the photovoltaic modules M within each of the classes, which have the similar characteristics, it becomes easy to perform the optimization of the wire connection pattern, and it becomes easy to form the wire connection pattern which may effectively use an output of each of the photovoltaic modules M without a waste at the same time.

Further, by the computation device 1, it is possible to form the string ST of the sunny class only by the photovoltaic modules M having high current values and to form the string ST of the shaded class only by the photovoltaic modules M having low current values. Accordingly, since each of the strings ST is formed by connecting the photovoltaic modules M having the similar current values in series, it is easy to perform the optimization of the wire connection pattern of each of the classes. Further, since a current difference between the modules within each of the strings ST is low, it is easy to increase a maximum output of the array formed by connecting the strings in parallel. That is, it is easy to form not the deformed output assembly AL as illustrated in Fig. 13 but the output assembly AL having a shape similar to a rectangle, and it is easy to increase the maximum output operation point Pmax. Further, the string ST, which can obtain a current value corresponding to that of the string ST of the sunny class, may be formed by using the pseudo modules VM, so that all the photovoltaic modules M may be used without a waste thereof.

Further, in the present embodiment, a sub array is formed for each of the classes such that the number of series is used after performing class classification based on only the current value, one array is configured by connecting the sub arrays in parallel. A voltage approximates an invariable parameter and an array is formed for each of the classes, so that a voltage difference between the classes needs not to be considered, and the wire connection pattern is simply selected. Further, in the present embodiment, one power conditioner 3 is provided for the power generation device 2.

Further, the string formation unit 13 connects the photovoltaic modules M belonging to the sunny class in series based on the number S of series set for the string ST of at least the sunny class, and the string ST including the left-over modules EM is formed by supplementing the left-over modules EM of which the number is lower than the number S of series with the pseudo module VM. In this way, even when there are the left-over modules EM of which the number is lower than the number S of series in the sunny class, the left-over modules EM may be supplemented by the pseudo modules VM, so as to contribute to the array output while being prevented from being useless.

Further, the wire connection pattern selection unit 17 selects a wire connection pattern according to the number of series when the output of the array is the largest, among the arrays formed by connecting the strings ST in parallel, with respect to the plurality of set numbers of series. Candidates of the wire connection patterns of the plurality of patterns may be made by only changing the number S of series of the string ST, and it is sufficient that an optimal number S of series is selected among the candidates, so that a computation load may be extremely reduced and a power generation efficiency may be improved.

Further, the string formation unit 13 may form each of the strings ST by arranging the photovoltaic modules M belonging to the sunny class in order of the current values, and may form the string ST of the shaded class by arranging the photovoltaic modules M, which are not used as the pseudo module VM, among the photovoltaic modules M belonging to the shaded class in order of the current values. Since it is sufficient to arrange the photovoltaic modules M in order of the current value, each of the strings ST may be easily formed. Meanwhile, since the photovoltaic modules M are arranged in order so that a current difference between the photovoltaic modules M in each of the strings ST becomes smaller, it is easy to increase the maximum output of the array A.

### [Second embodiment]

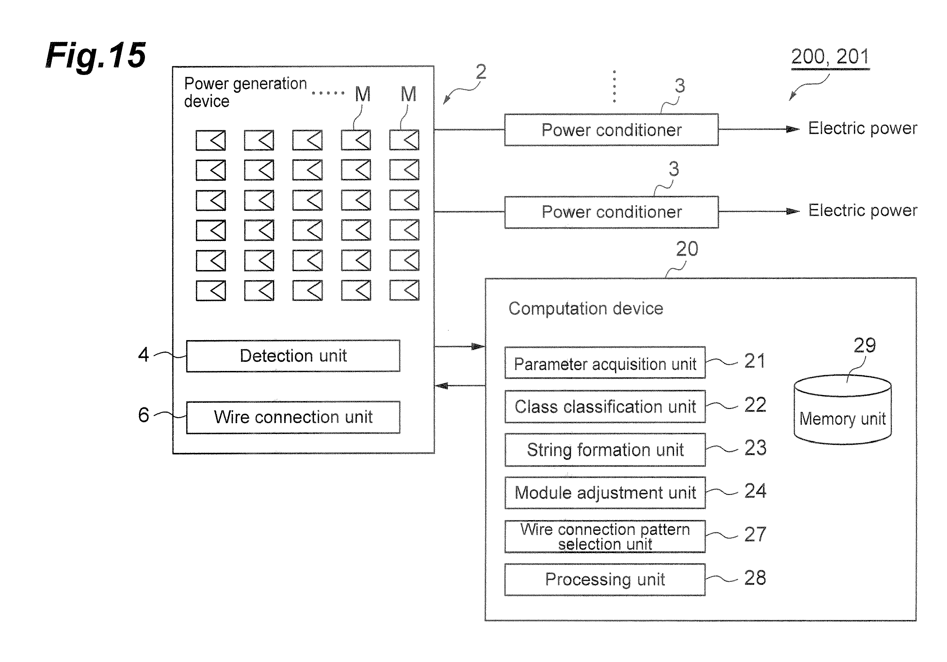

A computation device, a photovoltaic power generation system, and a method which optimizes photovoltaic power generation according to a second embodiment of the present invention will be described. The second embodiment is different from the first embodiment in that a change in a voltage value as well as the current value of each of the photovoltaic modules which is caused by the effect of the shade is considered and the wire connection pattern is selected by considering maximum output of each of the classes. As illustrated in Fig. 15, the photovoltaic power generation system 200 includes a computation device 20, a power generation device 2, and a power conditioner 3. A configuration of the power generation device 2 is equal to that of the first embodiment. The plurality of power conditioners 3 should be installed according to the number of classes.

The computation device 20 includes a parameter acquisition unit 21, a class classification unit 22, a string formation unit 23, a module adjustment unit 24, a wire connection pattern selection unit 27, a processing unit 28, and a memory unit 29.

The parameter acquisition unit 21 has a function of acquiring a parameter including at least a current value and a voltage value from each of the photovoltaic modules M by receiving output of the detection unit 4.

The class classification unit 22 has a function of classifying a class of each of the photovoltaic modules M based on the parameter. Further, the class classification unit 22 has a function of classifying the photovoltaic modules M which have similar parameters into the same class, in detail, into a class of which the parameter is high and a class of which the parameter is low. In the present embodiment, although the photovoltaic modules M are classified into a class α1 of which the parameter is the highest, a class α2 of which the parameter is intermediate, and a class α3 of which the parameter is the lowest, the photovoltaic modules M may be classified into more classes. Further, in the class classification, the number of classes may be previously limited, and the number of the photovoltaic modules M within the classes may be previously limited. Accordingly, the number of the photovoltaic modules M included in the classes may be set to be within a predetermined range so that a computation load may decrease.

The string formation unit 23 has a function of forming a string of the photovoltaic modules M for each of the classes. The string formation unit 23 may form a string ST (a first string) obtained by connection only the photovoltaic modules M belonging to a 1st class in series, and may form a string ST (a second string) obtained by connecting only the photovoltaic modules M belonging to a class lower than the 1 st class by one stage in series. Further, the string formation unit 23 has a function of forming a string of each of the classes based on maximum output of an array formed by the string of each of the classes. Further, the string formation unit 23 may form both of the two types of the strings ST or may form one of the two types of the strings ST, according to the number of the photovoltaic modules M of each of the classes. The string formation unit 23 connects the photovoltaic modules M belonging to each of the classes in series based on the number of series set for each of the classes. The number of series may be set to be the numbers (e.g. from 5 to 7) within a predetermined range by an allowance voltage of the power conditioner 3, etc., and the string formation unit 23 may form the string ST according to each of the numbers of series. Further, the string formation unit 23 has a function of forming a string corresponding to the 1^{st} class by arranging the photovoltaic modules M belonging to the corresponding class in order of the current value and forming a string ST corresponding to the class lower than the 1^{st} class by one stage by arranging the photovoltaic modules M belonging to the corresponding class in order of the current value.

The module adjustment unit 24 has a function of adjusting the photovoltaic modules in each of the classes. In detail, the module adjustment unit 24 has a function of moving the photovoltaic modules M from the class lower than the 1^{st} class by one stage according to a situation of generating left-over modules EM of the string in each of the classes or moving the photovoltaic modules M to the class lower than the 1^{st} class by one stage.

The wire connection pattern selection unit 27 has a function of selecting a wire connection pattern based on the class classification and a function of selecting a wire connection pattern to maximize maximum output of the array A configured by the wire connection of the photovoltaic modules M.

The processing unit 28 has a function of performing a process other than the process performed in each of the above-mentioned units 21 to 27. The memory unit 29 has a function of storing various information.

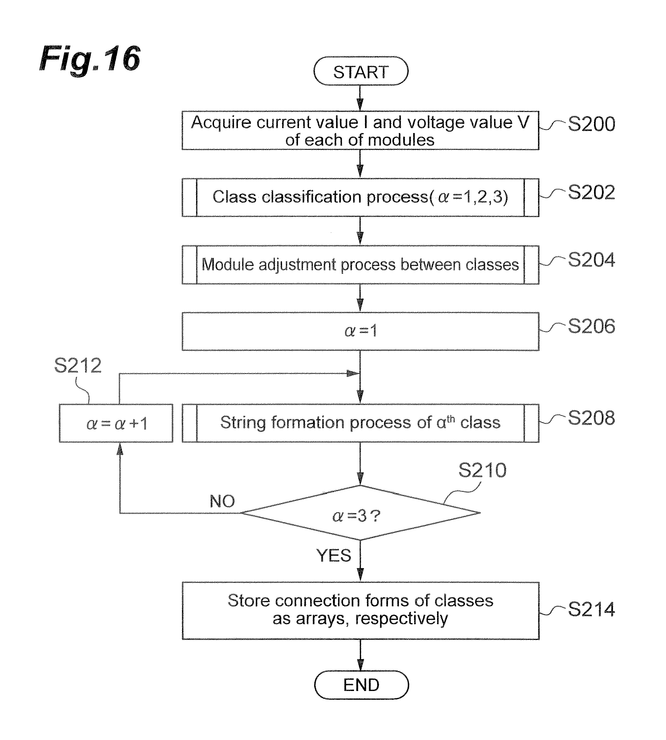

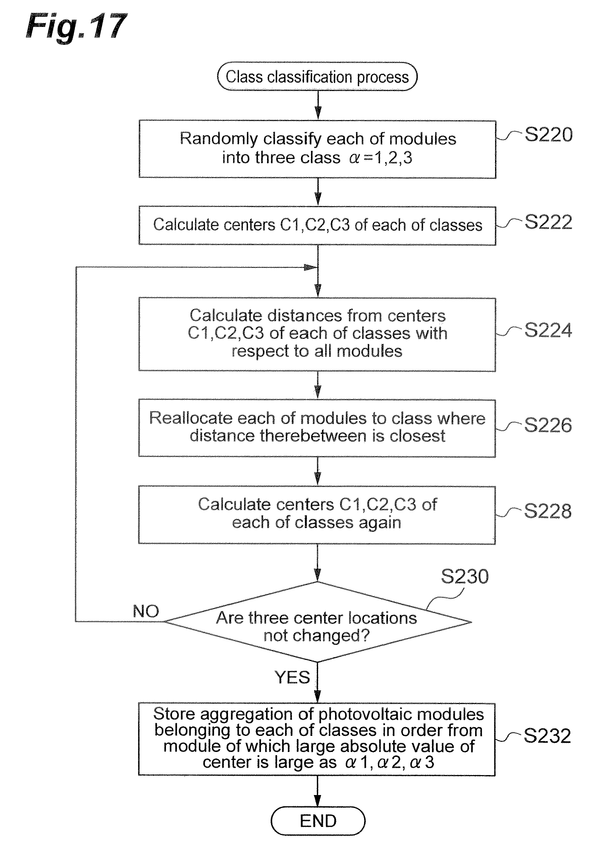

Next, a computation process of the computation device 20 will be described in detail with reference to Figs. 16 to 23. Fig. 16 is a flowchart illustrating processing executed when the computation device 20 selects an optimal wire connection pattern of the photovoltaic module. The process of Fig. 16 is executed at a predetermined timing of selecting the wire connection pattern, which is like the process of Fig. 2. Figs. 17 to 20 are flowcharts illustrating the processes of the Fig. 16 in detail, respectively.

In a control process according to the present embodiment, computation is performed while both a current and a voltage of the photovoltaic modules M of the shaded class are changed. Further, in an example of the control process illustrated in Fig. 16, each of the photovoltaic modules M is classified into one of three classes (α=1, 2, and 3). As illustrated in Fig. 16, the parameter acquisition unit 21 acquires a current value and a voltage value of each of the photovoltaic modules M (step S200). Next, the class classification unit 22 executes a class classification process of each of the photovoltaic modules M based on the current value and the voltage value acquired in step S200 (step S202). The class classification unit 22 classifies the plurality of photovoltaic modules M into "a class α1 (sunniest class)", "a class α2 (intermediate class)", and "a class α3 (shadiest class)".

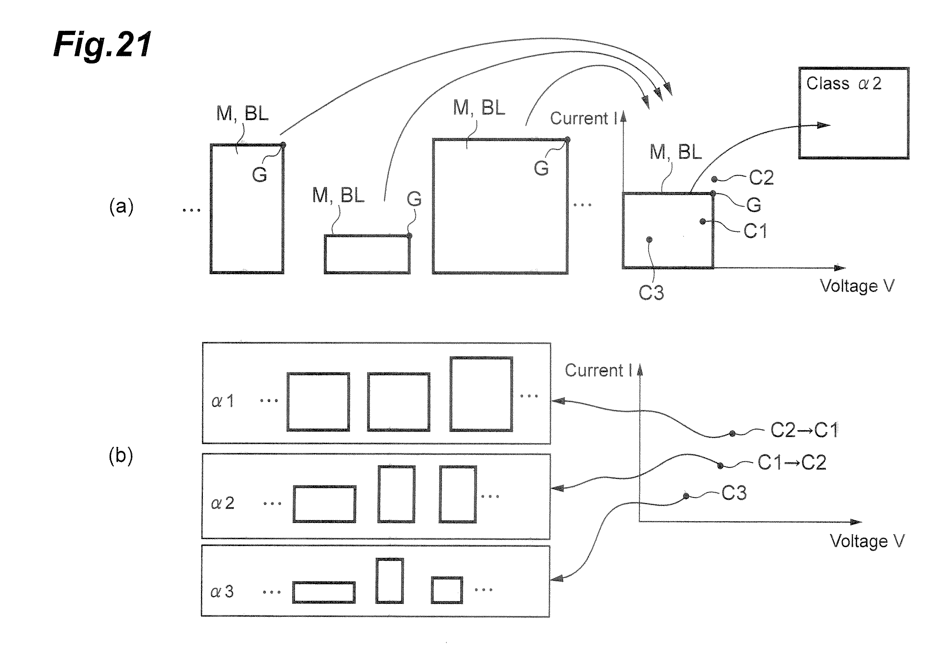

Here, a process of the class classification of step S202 will be described in detail with reference to Fig. 17. In Fig. 17, the class classification unit 22 performs class classification by considering a point at an upper right side (indicating a size of the parameter; hereinafter, referred to as "an upper right point") of an output block BL of each of the photovoltaic modules M (K-means method). The class classification unit 22 randomly classifies each of the photovoltaic modules M into the classes α1, α2, and α3 (step S220). Since adjusting between the classes is performed later, the number of the modules of each of the classes may be provisionally determined in this step. Further, in this step, the class classification is performed without considering magnitudes of currents and voltages of the classes α1, α2, and α3. Next, the class classification unit 22 calculates centers C1, C2, and C3 of the classes among coordinates of the current value-voltage value (step S222). In an example illustrated in Fig. 21A, the output blocks BL of the photovoltaic modules M in the class α1 which is provisionally classified are inserted into the coordinate plane one by one, and a center position is calculated from an average value of the output blocks BL and output blocks BL of other photovoltaic modules M. The corresponding calculation is performed with respect to all the photovoltaic modules M in the class α1, so that a point C1 illustrated in Fig. 21A is set as a center of the class α1. The calculation is performed with respect to the classes α2, α3 in the same manner, so that centers C2 and C3 are set.

Next, the class classification unit 22 computes distances between the upper right points G of all the photovoltaic modules M and the centers C1, C2, and C3 of the classes regardless of the class classification (step S224). Further, the class classification unit 22 reallocates all the photovoltaic modules M to the class, to which the closest center belongs, among the classes α1, α2, and α3 (step S226). In an example of Fig. 21A, an upper right point G of the output block BL of the photovoltaic module M inserted into the coordinate plane is closest to the center C2. Thus, the corresponding photovoltaic module M is relocated to the class α2. The centers C1, C2, and C3 of the classes α1, α2, and α3 are recalculated based on the upper right point G of each of the photovoltaic modules M reallocated in step S226 (step S228). When the class classification in the previous cycle is not sufficient, the centers C1, C2, and C3 reset in step S228 are different from the previously-set centers. The class classification unit 22 determines whether the recalculated centers C1, C2, and C3 are changed in comparison to those of the previous cycle (step S230). The corresponding determination may be determined as "not-changed" when the recalculated centers C1, C2, and C3 are completely equal to those of the previous cycle, and may be determined as "not-changed" when changes in the centers C1, C2, and C3 are within a predetermined range. When it is determined in step S230 that the centers C1, C2, and C3 are changed, step S224 to step S230 are performed again in order to more suitably perform the class classification.

Meanwhile, when it is determined in step S230 that the centers C1, C2, and C3 are not changed, the class classification unit 22 sets aggregations of the photovoltaic modules M belonging to each of the classes as the class α1, the class α2, and the class α3, in order from the class of which the absolute value of the center is large, and stores the set contents in the memory unit 29 (step S232). That is, the class classification unit 22 determines the class having the largest absolute value among the centers C1, C2, and C3 of the classes α1, α2, and α3 to which the class names are provisionally allocated, as the class name named "class α1". Further, the class classification unit 22 determines the class having the second largest absolute value among the centers C 1, C2, and C3 of the classes α1, α2, and α3 to which the class names are provisionally allocated, as the class name named "class α2". Further, the class classification unit 22 determines the class having the smallest absolute value among the centers C1, C2, and C3 of the classes α1, α2, and α3 to which the class names are provisionally allocated, as the class name named "class α3". Further, the absolute value of the center C1 herein is a distance between an original point (point where the current value is zero and the voltage value is zero) and the center C1. The absolute values of the centers C2 and C3 are defined in the same manner. In an example of Fig. 21, during the process of step S222 to step S230, the classes have been adjusted such that the absolute value of the center C2 of the provisionally-named class α2 is the largest and the absolute value of the center C1 of the provisionally-named class α1 is the second largest. However, as illustrated in Fig. 21B, by the process of step S232, the class name of the class which originally has the center C2 and is named "class α2" is determined as "class α1", and the class name of the class which has the center C1 and is named "the class α1" is determined as "class α2". Accordingly, the photovoltaic modules M having the largest output belong to "class α1", the photovoltaic modules M having the smallest output belong to "class α3", and the photovoltaic modules M having the intermediate output belong to "class α2".

Referring back to Fig. 16, the module adjustment unit 24 executes a module adjustment process between the classes (step S204). In the corresponding adjustment process, fine adjustment of the class classification of each of the classes is performed by considering the number of series of the string formed in each of the classes. Further, in the following description, the photovoltaic modules M (the output block BL thereof) of the class α1 refers to "the photovoltaic modules M₁ (the output block BL₁)", the photovoltaic modules M (the output block BL thereof) of the class α2 refers to "the photovoltaic modules M₂ (the output block BL₂)", and the photovoltaic modules M (the output block BL thereof) of the class α3 refers to "the photovoltaic modules M₃ (the output block BL₃)". Meanwhile, in the present embodiment, the number of series is set to be 5 to 7. Further, the number of the modules of the class α1 is set as m1, the number of the modules of the class α2 is set as m2, and the number of the modules of the class α3 is set as m3.

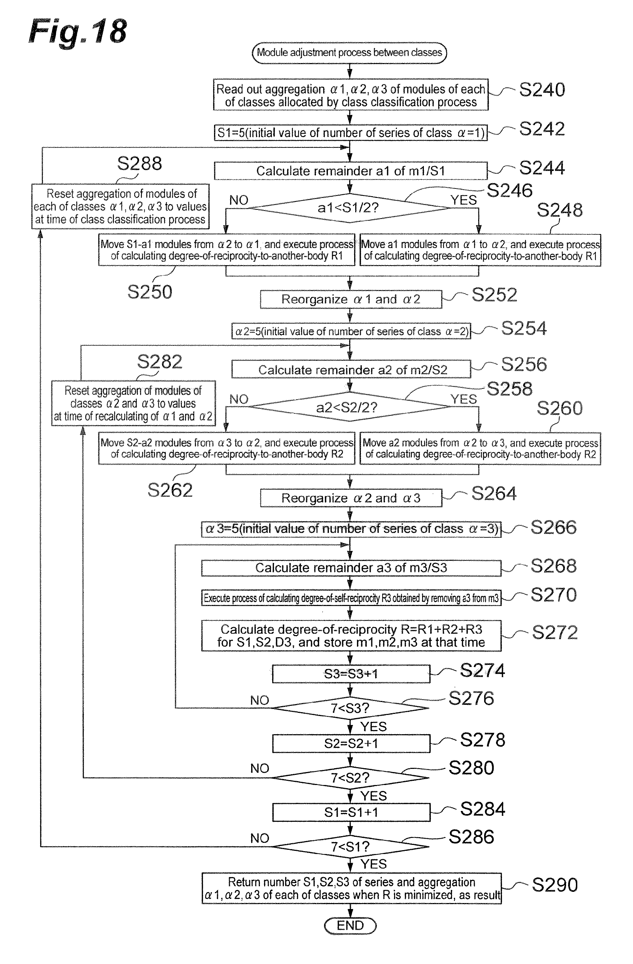

Here, a process of adjusting a module between the classes will be described in detail with reference to Fig. 18. As illustrated in Fig. 18, the module adjustment unit 24 reads out an aggregation of the photovoltaic modules M of each of the classes α1, α2, and α3 assigned by the class classification process, from the memory unit 19 (step S240). The module adjustment unit 24 sets an initial value of the number S1 of series of the class α1 to be 5 (step S242). Next, the module adjustment unit 24 calculates a remainder a1 of "a division of the number m1 of the modules by the number S1 of series" (step S244). Further, the module adjustment unit 24 determines whether the remainder a1 is smaller than a half of the number S1 of series (step S246).

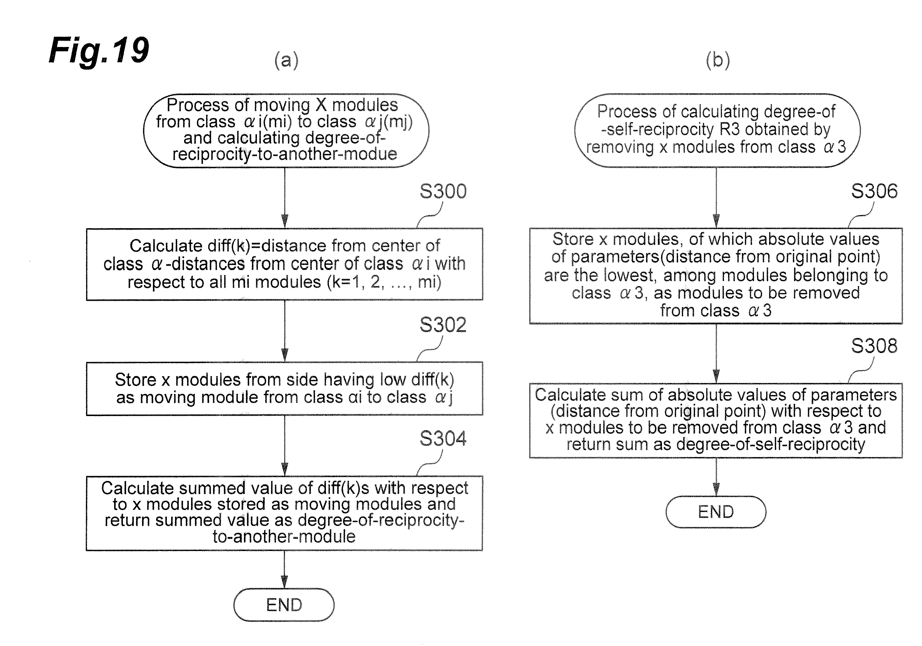

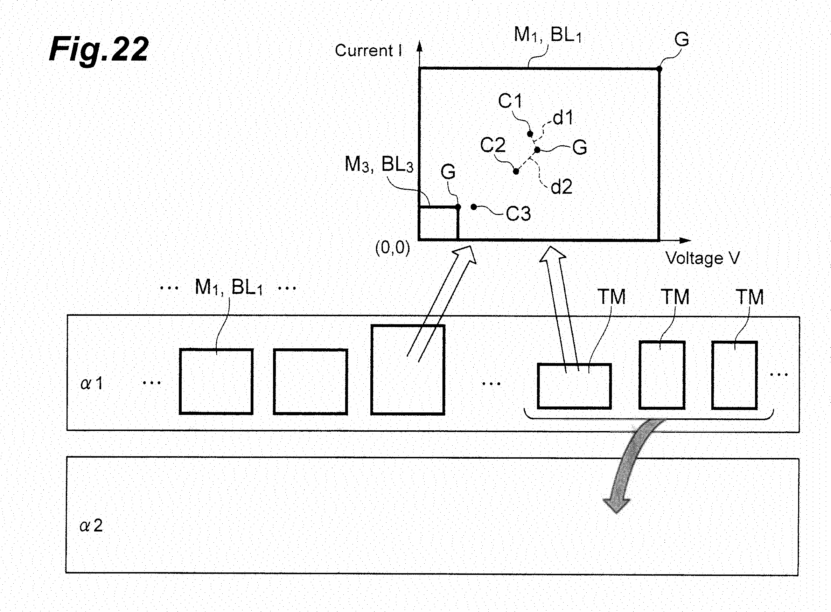

When it is determined in step S246 that the remainder a1 is smaller than a half of the number S of series, the module adjustment unit 24 moves the photovoltaic modules M₁ of which the number is the remainder a1 from the class α1 to the class α2, and executes a process of calculating a degree-of-reciprocity-to-another-body R1 (step S248). In this case, since the remainder in the class a1 is small and the class a1 needs to bring many photovoltaic modules M₂ from the class α2 which is lower than the class a1 by one stage in order to form a string, the remainder is wanted to be moved to the class α2. Here, the process of calculating the corresponding degree-of-reciprocity-to-another-body R1 will be described with reference to Figs. 19A and 22. Further, "the degree-of-reciprocity-to-another-body" is a parameter indicating how distant a photovoltaic module is from other photovoltaic modules of a destination (or other photovoltaic modules of a source place) when the photovoltaic module allocated to any one class moves to another class. That is, the degree-of-reciprocity-to-another-body is a parameter indicating how much the class of the destination or the class of the source place is affected by the corresponding moving. Here, in signs of Fig. 19A, the variable x is substituted for the remainder α1, i is substituted for 1, and j is substituted for 2.

As illustrated in Fig. 19A, the module adjustment unit 24 calculates "a dlff(k) which is equal to a value obtained by subtracting a distance d1 from the center C1 of the class a1 from a distance d2 from the center C2 of the class α2" with respect to centers of all (k=1,2,...,m1) the photovoltaic modules M₁ of which the number of the modules is m1 (step S300). Further, in the class classification method of Fig. 17, the center of the photovoltaic modules M₁ of the class α1 becomes closer to the center C1 than center C2, so that the dlff(k) is a positive value. Next, the module adjustment unit 24 stores the photovoltaic modules M₁ of which the number is "the remainder al" in order from a module having a low dlff(k) as a transfer module TM which is moved from the class α1 to the class α2, in the memory unit 29 (step S302). In an example of Fig. 22, a module of which the position is adjacent to the center C2 since the output is small is determined as the transfer module TM. Next, the module adjustment unit 24 calculates the summed value of the d1ff(k)s of the modules of which the number is "the remainder al" and which is stored as the transfer module TM, and acquires the corresponding summed value as the degree-of-reciprocity-to-another-body R1 (step S304).

When it is determined in step S246 that the remainder α1 is equal to or larger than a half of the number S of series, the module adjustment unit 24 moves the photovoltaic modules M₂ of which the number is "a value obtained by subtracting the remainder a1 from the number S1 of series" from the class α2 to the class α1, and executes a process of calculating the degree-of-reciprocity-to-another-body R1 (step S240). In this case, since a string may be formed when there is a large remainder in the class α1 and some photovoltaic modules M₂ are brought from the class α2 which is lower than the class a1 by one stage to the class α1, the shortage amount should be moved from the class α2 to the class α1. Here, in signs of Fig. 19A, the variable x is substituted for a value obtained by subtracting the remainder a1 from the number S 1 of series, i is substituted for 2, and j is substituted for 1. The order of the computation is equal to step S248.

Next, the module adjustment unit 24 reorganizes the modules of the class α1 and the class α2 based on the process result of the step S248 or step S250 (step S252). The module adjustment unit 24 moves the photovoltaic modules M₁ determined as the transfer module TM in step S248 from the class α1 to the class α2. Otherwise, the module adjustment unit 24 moves the photovoltaic modules M₂ determined as the transfer module TM in step S250 from the class α2 to the class α1.

Next, the module adjustment unit 24 sets an initial value of the number S2 of series of the class α2 to be 5 (step S254). Next, the module adjustment unit 24 calculates a remainder a2 of "divining of the number of the modules m2 by the number S2 of series" (step S256). Further, the module adjustment unit 24 determines whether the remainder a2 is smaller than a half of the number S2 of series (step S258).

When it is determined in step S258 that the remainder a2 is smaller than a half of the number S2 of series, the module adjustment unit 24 moves the photovoltaic modules M₂ of which the number is the remainder a2 from the class α2 to the class α3, and executes a process of calculating a degree-of-reciprocity-to-another-body R2 (step S260). In this case, since the remainder in the class α2 is small and the class α2 needs to bring many photovoltaic modules M₃ from the class α3 which is lower than the class α2 by one stage in order to form a string, the remainder should be moved to the class α3. Here, in signs of Fig. 19A, the variable x is substituted for the remainder a2, i is substituted for 2, and j is substituted for 3. The order of the computation is equal to step S248.

When it is determined in step S258 that the remainder a2 is equal to or larger than a half of the number S2 of series, the module adjustment unit 24 moves the photovoltaic modules M₃ of which the number is "a value obtained by subtracting the remainder a2 from the number S2 of series" from the class α3 to the class α2, and executes a process of calculating the degree-of-reciprocity-to-another-body R2 (step S262). In this case, since a string may be formed when there is a large remainder in the class α2 and some photovoltaic modules M₃ are brought from the class α3 which is lower than the class α2 by one stage to the class α2, the shortage amount should be moved from the class α3 to the class α2. Here, in signs of Fig. 19A, the variable x is substituted for a value obtained by subtracting the remainder a2 from the number S2 of series, i is substituted for 3, and j is substituted for 2. The order of the computation is equal to step S248.

Next, the module adjustment unit 24 reorganizes the modules of the class α2 and the class α3 based on the process result of the step S260 or step S262 (step S264). The module adjustment unit 24 moves the photovoltaic modules M₂ determined as the transfer module TM in step S260 from the class α2 to the class α3. Otherwise, the module adjustment unit 24 moves the photovoltaic modules M₃ determined as the transfer module TM in step S262 from the class α3 to the class α2.

Next, the module adjustment unit 24 sets an initial value of the number S3 of series of the class α3 to be 5 (step S266). Next, the module adjustment unit 24 calculates a remainder a3 of "dividing the number m3 of the modules by the number S3 of series" (step S268). Further, the module adjustment unit 24 executes a process of calculating a degree-of-self-reciprocity R3 when the photovoltaic modules M₃ of which the number is the remainder a3 are removed from the class α3 (the number of the modules is m3)(step S270). There is no class lower than the class α3, so that the remaining modules are instantly removed.

Here, the process of calculating the degree-of-self-reciprocity R3 will be described with reference to Fig. 19B. Further, "the degree-of-self-reciprocity" refers to a parameter indicating how much the class α3 is affected by removing the modules from the class α3 when the corresponding modules are removed from the class α3. In signs of Fig. 19B, the variable x is substituted for the remainder a3.

As illustrated in Fig. 19B, the module adjustment unit 24 stores the photovoltaic modules M₃ of which the number is "the remainder a3" and which have the lowest absolute values of the parameters (e.g. as illustrated in Fig. 22, a distance between the upper right point G of the photovoltaic module and the original point where the current value is zero and the voltage value is zero) among the photovoltaic modules M₃ belonging to the class α3, as the transfer module TM which is removed from the class α3, in the memory unit 29 (step S306). Next, the module adjustment unit 24 calculates the sum of the absolute values of the parameter of the transfer module TM of which the number is the remainder a3, and acquires the sum as the degree-of-self-reciprocity R3 (step S308).

Referring to Fig. 18, the module adjustment unit 24 calculates a degree-of-reciprocity R obtained by summing the degree-of-reciprocity-to-another-body R1 and R2 and the degree-of-self-reciprocity R3 with respect to the numbers S1, S2, and S3 of series, and stores the corresponding degree-of-reciprocity R together with the numbers m1, m2, and m3 of the modules of each of the classes at that time, in the memory unit 29 (step S272). Next, the module adjustment unit 24 adds 1 to the number S3 of series of the class α3 (step S274). Further, the module adjustment unit 24 determines whether the number S3 of series is larger than 7 (step S276). When the number S3 of series is equal to or smaller than 7, the processes of step S268 to step S276 are performed again. Accordingly, the degree-of-reciprociy R and the numbers m1, m2, and m3 of the modules of all the patterns when the number S1 of series is 5, the number S2 of series is 5, and the number S3 of series is 5, 6, and 7, respectively, are stored. When the number S3 of series is larger than 7, the module adjustment unit 24 adds 1 to the number S2 of series of the class α2 (step S278). Further, the module adjustment unit 24 determines whether the number S2 of series is larger than 7 (step S280). When the number S2 of series is equal to or smaller than 7, the module adjustment unit 24 resets the module configuration of the classes α2 and α3 to that of step S252 (step S282). Thereafter, the processes of step S256 to step S280 are performed again. Accordingly, the degree-of-reciprocity R and the numbers m1, m2, and m3 of the modules of all the patterns when the number S1 of series is 5, the number S2 of series is 5, 6, and 7, respectively, and the number S3 of series is 5, 6, and 7, respectively, are stored. When the number S1 of series is larger than 7, the module adjustment unit 24 adds 1 to the number S1 of series of the class α1 (step S284). Further, the module adjustment unit 24 determines whether the number S1 of series is larger than 7 (step S286). When the number S2 of series is equal to or smaller than 7, the module adjustment unit 24 resets the module configuration of the classes α1, α2, and α3 to that at a time of the class classification process (i.e. that at a time of starting the process of Fig. 18) (step S288). Thereafter, the processes of step S244 to step S286 are performed again. Accordingly, the degree-of-reciprocity R and the numbers m1, m2, and m3 of the modules of all the patterns when the number S1 of series is 5, 6, and 7, respectively, the number S2 of series is 5, 6, and 7, respectively, and the number S3 of series is 5, 6, and 7, respectively, are stored.

When the computation of all the patterns of the numbers S 1, S2, and S3 of series is terminated, the module adjustment unit 24 acquires the numbers S1, S2, and S3 of series and the aggregation of the modules of each of the classes α1, α2, and α3 when the degree-of-reciprocity R is a minimum, as a condition for forming a string, and returns the corresponding result (step S290).

Referring back to Fig. 16, the processing unit 28 sets a class forming a string as the class α1 (step S206). The string formation unit 23 executes a process of forming a string for the first class, i.e. the class α1 (step S208).

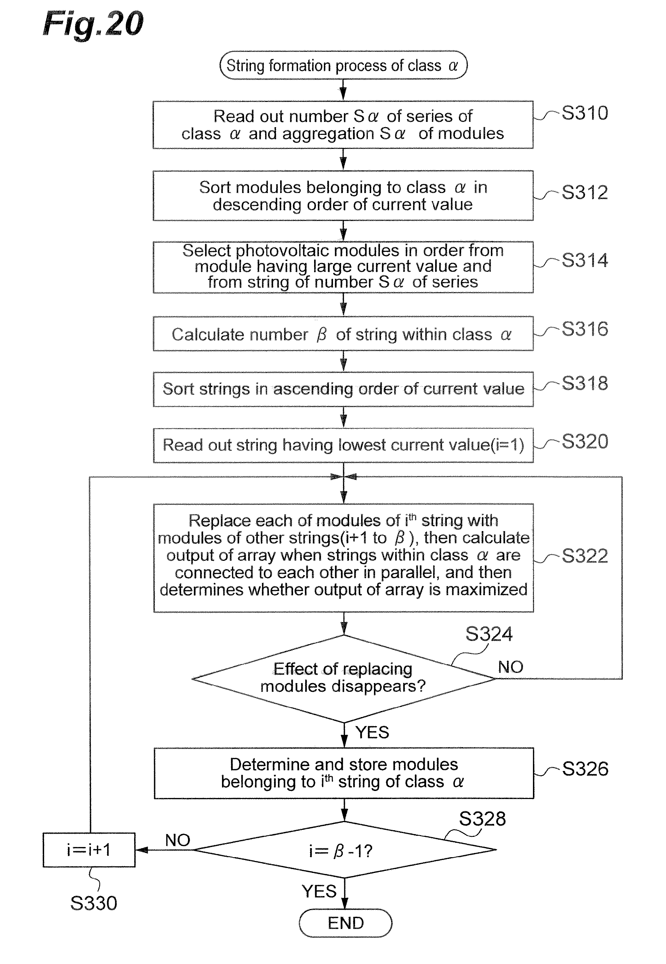

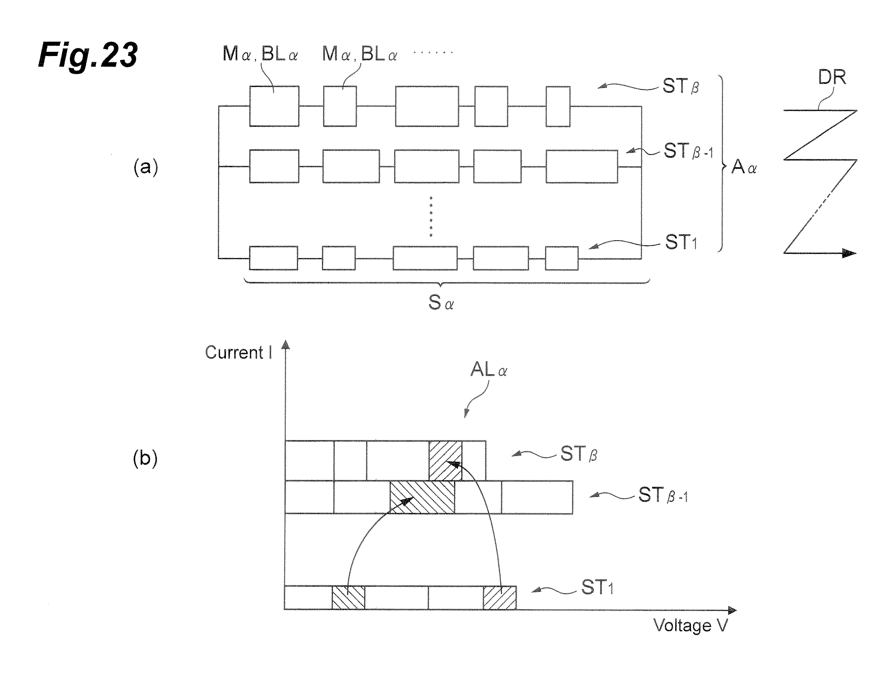

Here, a process of forming a string of a predetermined class will be described in detail with reference to Fig. 20. As illustrated in Fig. 20, the string formation unit 23 reads out the number S1 of series of the class α1 and the aggregation (the result stored in step S290 of Fig. 18) of the photovoltaic modules M₁ of the corresponding class α1 (step S310). The string formation unit 23 sorts the photovoltaic modules M₁ belonging to the class α1 in descending order of the current value (step S312). Here, the voltage value is not considered, and only the current value is considered. The string formation unit 23 selects the photovoltaic modules M₁ in order from a side having a large current value, and forms a string of the number S1 of series (step S314). Further, the string formation unit 23 calculates the number β of the strings of the string ST within the class α1 (step S316). Further, the string formation unit 23 sorts the strings ST in ascending order of the current value (step S318). Accordingly, an array A₁ is formed as illustrated in Fig. 23A, and an output assembly AL₁ is formed as illustrated in Fig. 23B. In the array A₁ illustrated in Fig. 23A, the photovoltaic modules M₁ are arranged in a direction of an arrow indicated by DR of the drawing in order from a module having a large current value. Strings ST₁, ST₂, ..., ST_{β-1}, ST_{β} of the number S1 of series are formed in order from a module having a low current value. Further, as illustrated in Fig. 23B, the output blocks BL₁ are stacked in order of the strings ST₁, ST₂, ..., ST_{β-1}, ST_{β} from the below, and the output assembly AL₁ is formed. Further, since only the current value is considered and the voltage value is not considered in this step, the summed voltage value of each of the strings ST is not used.

Next, the string formation unit 23 reads out the string ST₁ which has the lowest current value (step S320). The string formation unit 23 replaces each of the photovoltaic modules M₁ (the output blocks BL₁) of the string ST₁ with the photovoltaic modules M₁ (the output blocks BL₁) of the other strings ST₂ to ST_{β}, then calculates output of the array A₁ of a case where the strings ST within the class α1 are connected to each other in parallel, and then determines whether the output is maximized (step S322). For example, as illustrated in Fig. 23, any one of the photovoltaic modules M₁ (the output blocks BL₁) of the string ST₁ is replaced with any one of the photovoltaic modules M₁ (the output blocks BL₁) of another string ST, and an output of the reorganized array A₁ is calculated. Further, it is determined whether the maximum output increases by the corresponding reorganization. Next, the string formation unit 23 determines whether the effect of replacing modules disappears (step S324). That is, when it is determined that the module replacement in all the patterns is performed and the output of the array A₁ does not increase any more even when the reorganization is performed, it is determined that the effect of replacing modules disappears. When it is determined in step S324 that the output increases by the module replacement, another replacement pattern is executed again in step S322, and a combination which can further increase the output is formed. Meanwhile, when it is determined in step S324 that the effect of replacing modules disappears, the string formation unit 23 determines the photovoltaic modules M₁ belonging to the string ST₁ of the class α1, and stores the determined result in memory unit 29.

Thereafter, the string formation unit 23 determines whether the string number i becomes β-1 (step S328). That is, the string formation unit 23 determines whether the photovoltaic modules M₁ are determined for all the strings ST (further, since there is no string to be replaced with the string ST_{β} having the highest current value, the module replacement for the string ST_{β} is not performed). When it is determined in step S328 that the string number i is not β-1, the string formation unit 23 adds 1 to the string number i (step S330), and the processes of step S322 to step S328 are performed again. At this time, the photovoltaic modules M₁ (the output blocks BL₁) of the already-determined string ST is not used for the module replacement. When it is determined in step S328 that the string number i becomes β-1, it is determined that the configuration of the photovoltaic modules M₁ of all the strings ST is determined, so that the process of Fig. 20 is terminated.

Referring back to Fig. 16, the processing unit 28 determines whether α of the current class is 3 (step S210). That is, it is determined whether the process of forming the string for all the classes is completed When it is determined in step S210 that α is not 3, 1 is added to the α, and the process of forming a string is performed for the next class. Accordingly, the strings ST for the classes α2 and α3 are formed. As described above, the wire connection pattern which can increase the maximum output for each of the classes is formed.

The wire connection pattern selection unit 27 selects a connection pattern of the photovoltaic modules M of each of the classes α1, α2, and α3 as an array A to be adopted, and stores the selected connection pattern in memory unit 29 (step S214). The wire connection pattern selection unit 27 selects a pattern obtained by connecting each string determined for the class α1, each string determined for the class α2, and each string determined for the class α3 in parallel, as a wire connection pattern of the array A. When the process of step S214 is terminated, the wire connection pattern to be adopted is determined, and the process of Fig. 16 is terminated.

Next, the operation and the effect of the present embodiment will be described.

By the computation device 20, the class classification unit 22 performs the class classification of the photovoltaic modules M based on the parameter including the current value of each of the photovoltaic modules M. That is, since the optimization of the wire connection pattern of each of the classes may be performed by performing the class classification even when the number of the photovoltaic modules M increases, a computation load is reduced as compared with a case of performing computation after organizing the wire connection pattern of the plurality of photovoltaic modules. Accordingly, the wire connection pattern is effectively selected, so that the power generation performance is improved while the computation load is reduced.

Further, the class classification unit 22 classifies the photovoltaic modules M of which the parameters have similar values into the same class. Accordingly, the string ST and the array A may be configured by using the photovoltaic modules M within each of the classes, which have similar characteristics, it becomes easy to perform the optimization of the wire connection pattern, and it becomes easy to form the wire connection pattern which may effectively use an output of each of the photovoltaic modules M without a waste at the same time.

By the computation device 20, it is possible to form a string ST of the class α1 only by the photovoltaic modules M having a large parameter, and form strings ST of the lower classes α2 and α3 only by the photovoltaic modules M having a small parameter. Accordingly, since each of the strings ST is formed by connecting the modules having similar parameters in series, it is easy to perform the optimization of the wire connection pattern of each of the classes. Further, since a current difference between the modules within each of the strings ST is low, it is easy to increase a maximum output of the array formed by connecting the strings ST in parallel. That is, it is easy to form not the deformed output assembly AL as illustrated in Fig. 13 but the output assembly AL having a shape similar to a rectangle, and it is easy to increase the maximum output operation point Pmax. Further, since the string ST of the class α1 is formed based on the maximum output of the array (the output assembly AL of the class α1) formed by the string ST of the corresponding class α1, the string ST of the class α21 is formed based on the maximum output of the array (the output assembly AL of the class α2) formed by the string ST of the corresponding class α2, and the string ST of the class α3 is formed based on the maximum output of the array (the output assembly AL of the class α3) formed by the string ST of the corresponding class α3, a user has only to independently optimize the wire connection pattern of the array in each of the classes and a computation load is reduced.

Further, in the present embodiment, the class classification is performed based on the current value and the arrays are then configured for each of the classes. The power conditioners 3 are installed in each of the classes and the arrays are formed in each of the classes, so that the difference between the voltages of the classes is not needed to be considered, so that the wire connection patterns may be simply selected.

Further, the string formation unit 23 forms the string ST of the class α1 by arranging the photovoltaic modules M₁ belonging to the class α1 in order of the current values, forms the string ST of the class α2 by arranging the photovoltaic modules M₂ belonging to the class α2 in order of the current values, and forms the string ST of the class α3 by arranging the photovoltaic modules M₃ belonging to the class α3 in order of the current values. Since it is sufficient to arrange the photovoltaic modules M in order of the current value, each of the strings ST may be easily formed. Meanwhile, since the photovoltaic modules M are arranged in order so that a current difference between the photovoltaic modules M in each of the strings ST becomes smaller, it is easy to increase the maximum output of the array A.

### [Third embodiment]

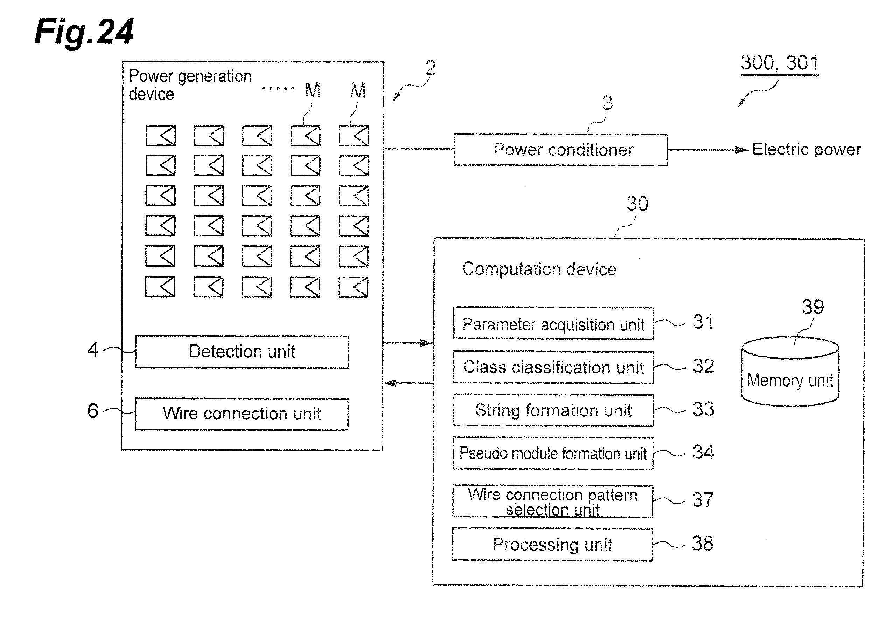

A computation device, a photovoltaic power generation system, and a method which optimizes photovoltaic power generation according to a third embodiment of the present invention will be described. The third embodiment is different from the first embodiment in that a change in a voltage value as well as the current value of each of the photovoltaic modules which is caused by the effect of the shade is considered and the string is formed by connecting the pseudo module VM in series as well as in parallel. As illustrated in Fig. 24, the photovoltaic power generation system 300 includes a computation device 30, a power generation device 2, and a power conditioner 3. A configuration of the power generation device 2 is equal to that of the first embodiment. One power conditioner 3 is installed for the power generation device 2.

The computation device 30 includes a parameter acquisition unit 31, a class classification unit 32, a string formation unit 33, a pseudo module formation unit 34, a wire connection pattern selection unit 37, a processing unit 38, and a memory unit 39.

The parameter acquisition unit 31 has a function of acquiring a parameter including at least a current value and a voltage value from each of the photovoltaic modules M by receiving an output of the detection unit 4.

The class classification unit 32 has a function of classifying a class of each of the photovoltaic modules M based on the parameter. Further, the class classification unit 32 has a function of classifying the photovoltaic modules M which have similar parameters into the same class, in detail, into a class of which the current value is high and a class of which the current value is low. In the present embodiment, although the photovoltaic modules M are classified into a class α1 of which the current is the highest, a class α2 of which the current is intermediate, and a class α3 of which the current is the lowest, the photovoltaic modules M may be classified into more classes. Meanwhile, in the class classification, the number of classes may be previously limited, and the number of the photovoltaic modules M within the classes may be previously limited. Accordingly, the number of the photovoltaic modules M included in the classes may be set to be within a predetermined range, and a computation load may decrease.

The string formation unit 33 has a function of forming a string of the photovoltaic modules M for each of the classes. The string formation unit 33 may form a string ST (a first string) obtained by connecting only the photovoltaic modules M belonging to the class of 1 in series, a string ST (a second string) obtained by connecting only the photovoltaic modules M belonging to the class lower than the class of 1 by one stage in series, a string ST (a third string) obtained by connecting left-over modules EM of the photovoltaic modules belonging to the higher class and pseudo modules VM configured by the photovoltaic modules M belonging to the class lower the upper class by one stage in series. Further, the string formation unit 33 may form all of the three types of the strings ST, only two types of the strings among the three types of the strings, or only one type of the strings among the three types of the strings, according to the number of the photovoltaic modules M within each of the classes. The string formation unit 33 connects the photovoltaic modules M belonging to the class α1 in series based on the number of series set for the class α1, and forms a string ST including the left-over modules EM by supplementing the left-over modules EM of which the number is lower than the number of series with the pseudo modules VM. The number of series may be set to be the numbers (e.g. from 5 to 7) within a predetermined range by an allowance voltage of the power conditioner 3, etc., and the string formation unit 33 may form the string ST according to each of the numbers of series. The strings ST of the lower classes α2 and α3 are formed based on the summed voltage of the string ST of the class α1. Further, the string formation unit 33 has a function of forming each of the strings ST by arranging the photovoltaic modules M belonging to the class of 1 in order of the current values, and forming the string ST by arranging the photovoltaic modules M, which are not used as the pseudo modules VM, among the photovoltaic modules M belonging to the class lower by one stage in order of the current values.

The pseudo module formation unit 34 has a function of forming the pseudo modules VM by connecting the plurality of photovoltaic modules M belonging to the class lower by one stage in parallel (or, in series if necessary) based on the parameter (the current value and the voltage value) of the photovoltaic modules M belonging to the class of 1.

The wire connection pattern selection unit 37 has a function of selecting a wire connection pattern based on the class classification and a function of selecting a wire connection pattern to maximize maximum output of the array A configured by the wire connection of the photovoltaic modules M.

The processing unit 38 has a function of performing a process other than the process performed in each of the above-mentioned units 31 to 37. The memory unit 39 has a function of storing various information.

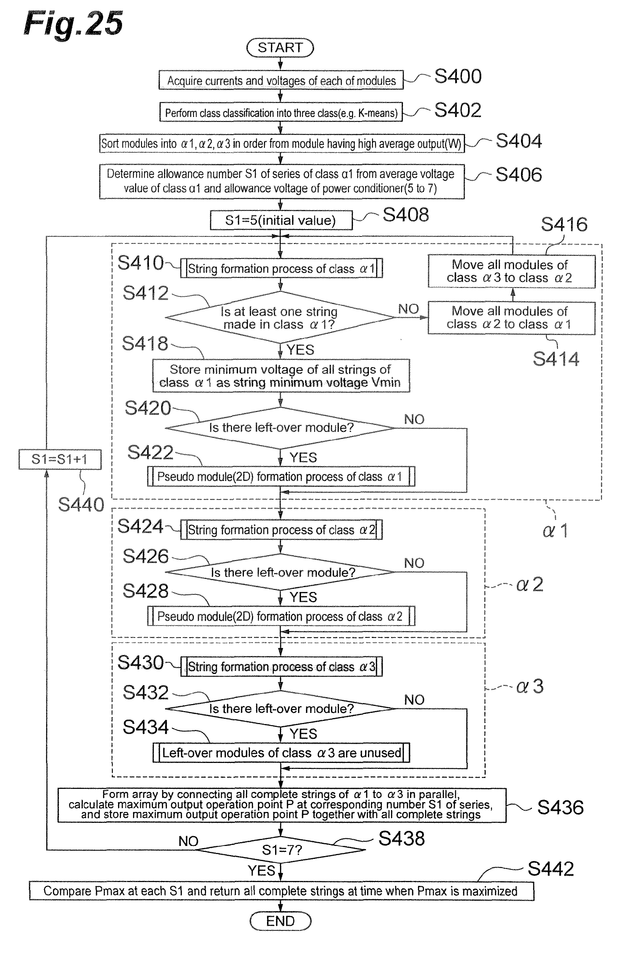

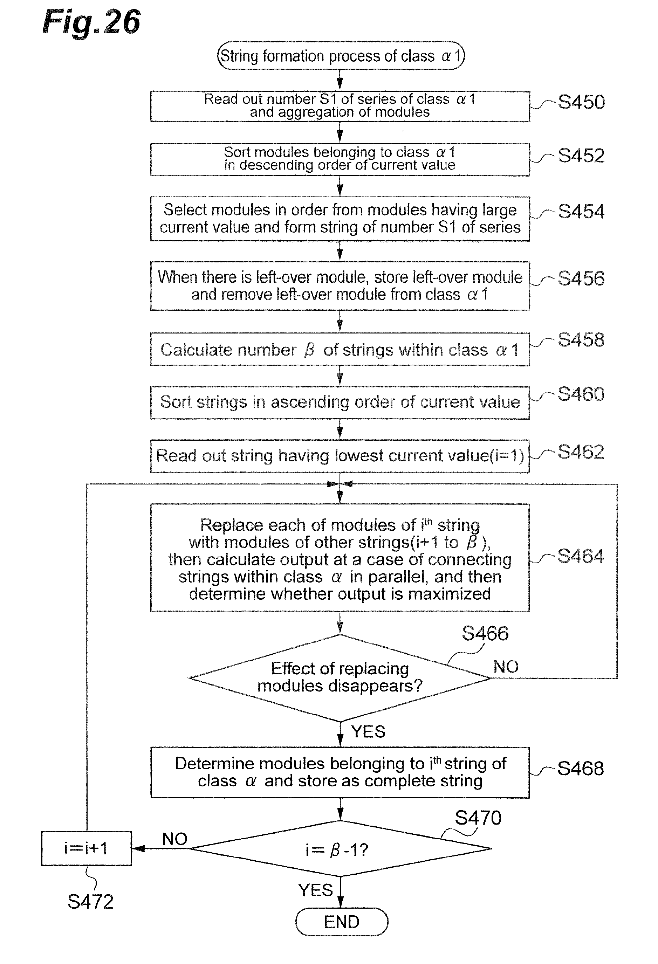

Next, a computation process of the computation device 30 will be described in detail with reference to Figs. 25 to 31. Fig. 25 is a flowchart illustrating processing executed when the computation device 30 selects an optimal wire connection pattern of the photovoltaic module. The process of Fig. 25 is executed at a predetermined timing of selecting the wire connection pattern, which is like the process of Fig. 2. Figs. 26 to 28 are flowcharts illustrating the processes of the Fig. 25 in detail, respectively.

In a control process according to the present embodiment, computation is performed based on assumption that both of a current and a voltage of the photovoltaic modules M of the shaded class are changed. Further, in an example of the control process illustrated in Fig. 25, each of the photovoltaic modules M is classified into one of three classes (α=1, 2, and 3). As illustrated in Fig. 25, the parameter acquisition unit 31 acquires a current value and a voltage value of each of the photovoltaic modules M (step S400). Next, the class classification unit 32 executes a class-classification process of each of the photovoltaic modules M based on the current value and the voltage value acquired in step S400 (step S402). The class classification unit 32 classifies the plurality of photovoltaic modules M into "a class α1 (sunniest class)", "a class α2 (intermediate class)", and "a class α3 (shadiest class)". In the class classification of step S402, the class classification may be performed by using, for example, the K-means method described in Fig. 17 of the second embodiment. After performing the class classification into three classes in step S402, the photovoltaic modules M are classified into the class α1, the class α2, and the class α3 in order from a module having high average output (W) among the photovoltaic modules M within the classes (step S404).

Next, the processing unit 38 determines an allowance number S1 of series of the class α1 based on an average voltage value of the class α1 and an allowance voltage of the power conditioner 3 (step S406). Here, the S1 is set to be 5 to 7. Next, the processing unit 38 sets the number S1 of series of the class α1 to be 5 (step S408). Next, the string formation unit 33 executes a process of forming a string of the class α1 (step S410).

Here, a process of forming a string of the class α1 will be described in detail with reference to Fig. 26. As illustrated in Fig. 26, the string formation unit 33 reads out the number S1 of series of the class α1 and the aggregation of the photovoltaic modules M₁ of the corresponding class α1, from the memory unit 39 (step S450). The string formation unit 33 sorts the photovoltaic modules M₁ belonging to the class α1 in descending order of the current value (step S452). Here, the voltage value is not considered, and only the current value is considered. The string formation unit 33 selects the photovoltaic modules M₁ in order from a side having a large current value, and forms a string of the number S1 of series (step S454). Here, when there is a left-over module EM, the string formation unit 33 stores the corresponding module as the left-over module EM in the memory unit 39 and removes the corresponding module from the class α1 (step S456). Further, the string formation unit 33 calculates the number β of the strings of the string ST within the class α1 (step S458). Further, the string formation unit 33 sorts the strings ST in ascending order of the current value (step S460). Accordingly, an array A₁ is formed as illustrated in Fig. 23A, and an output assembly AL₁ is formed as illustrated in Fig. 23B, which is like the process of forming the string in the second embodiment.

Next, the string formation unit 33 reads out the string ST₁ which has the lowest current value (step S462). The string formation unit 33 replaces each of the photovoltaic modules M₁ (the output blocks BL₁) of the string ST₁ with the photovoltaic modules M₁ (the output blocks BL₁) of the other strings ST₂ to ST_{β}, then calculates output of the array A₁ of a case where the strings ST within the class α1 are connected to each other in parallel, and then determines whether the output is maximized (step S464). For example, as illustrated in Fig. 23, any one of the photovoltaic modules M₁ (the output blocks BL₁) of the string ST₁ is replaced with any one of the photovoltaic modules M₁ (the output blocks BL₁) of another string ST, and output of the reorganized array A₁ is calculated. Further, it is determined whether the maximum output increases by the corresponding reorganization. Next, the string formation unit 23 determines whether the effect of replacing modules disappears (step S466). That is, when it is determined that the module replacement in all the patterns is performed and the output of the array A₁ does not increase any more even when the reorganization is performed, it is determined that the effect of replacing modules disappears. When it is determined in step S466 that the output increases by the module replacement, another replacement pattern is executed again in step S464, and a combination which can further increase the output is formed. Meanwhile, when it is determined in step S466 that the effect of replacing modules disappears, the string formation unit 33 determines the string ST according to the corresponding combination as a complete string ST_{CP} of the class α1, and stores the determined contents in memory unit 39 (step S468).

Thereafter, the string formation unit 33 determines whether the string number i becomes β-1 (step S470). That is, the string formation unit 33 determines whether the photovoltaic modules M₁ are determined for all the strings ST (further, since there is no string to be replaced with the string ST_{β} having the highest current value, the module replacement for the string ST_{β} is not performed). When it is determined in step S470 that the string number i is not β-1, the string formation unit 33 adds 1 to the string number i (step S472), and the processes of step S322 to step S328 are performed again. At this time, the photovoltaic modules M₁ (the output blocks BL₁) of the already-determined string ST is not used for the module replacement. When it is determined in step S470 that the string number i becomes β-1, it is determined that the configuration of the photovoltaic modules M₁ of all the strings ST is determined, so that the process of Fig. 26 is terminated.

Referring back to Fig. 25, the processing unit 38 determines whether at least one string ST of the class α1 has been formed (step S412). When it is determined in step S412 that the number of the photovoltaic modules M₁ belonging to the class α1 is too small so that a string ST cannot be formed, the processing unit 38 moves all the photovoltaic modules M₂ belonging to the class α2 to the class α1 (step S414). Further, the processing unit 38 moves all the photovoltaic modules M₃ belonging to the class α3 to the class α2 (step S416). Thereafter, the processes of step S410 and step S412 are executed again. The processing unit 38 determines a minimum voltage among voltages (sum of the voltage values of the output blocks BL of the string ST) of all the strings ST of the class α1 as a string minimum voltage Vmin, and stores the determined string minimum voltage in the memory unit 39 (step S418). The processing unit 38 determines whether there is a left-over module EM in the class α1 by referring to the information stored in step S456 of Fig. 26 (step S420). When it is determined in step S420 that there is a left-over module EM, the pseudo module formation unit 34 executes a process of forming a pseudo module (step S422), and when it is determined in step S420 that there are no left-over modules EM, step S422 is skipped and the process proceeds to step S424.

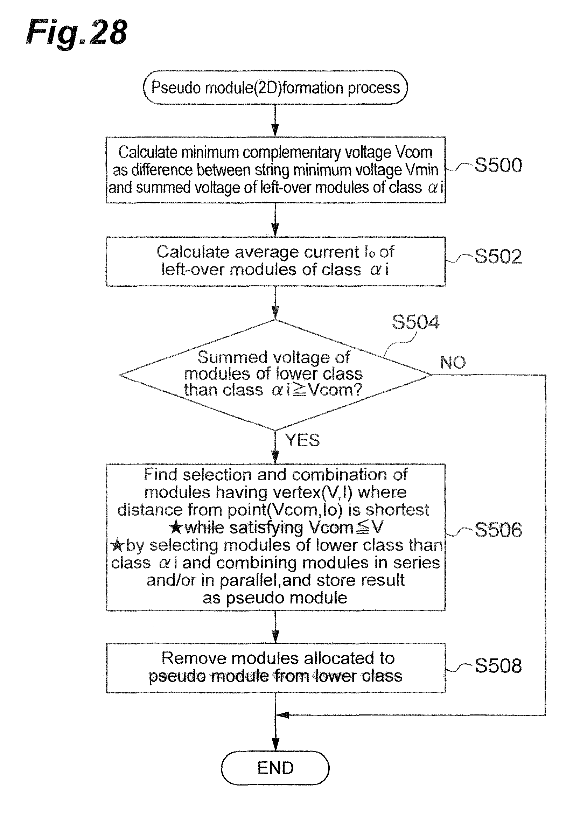

A process of forming a pseudo module will be described in detail with reference to Fig. 28. The pseudo module formation unit 34 calculates a minimum complementary voltage Vcom as a difference between the minimum voltage Vmin stored in step S418 of Fig. 25 and the summed voltage of the left-over modules EM of the class α1 (step S500). The minimum complementary voltage Vcom corresponds to a voltage to be minimally complemented to ensure that the voltage of the string is equal to or larger than the minimum voltage Vmin when the string is formed by using the left-over modules EM. The pseudo module formation unit 34 calculates an average current Io of the left-over modules EM in the class α1 (step S502).

Next, the pseudo module formation unit 34 determines whether the summed voltage of the photovoltaic modules M₂ of the class α2 lower than the class α1 is equal to or larger than the minimum complementary voltage Vcom (step S504). The photovoltaic modules M₂ of the class α2 lower by one stage cannot originally secure the minimum complementary voltage Vcom, and when it is determined in step S504 that the summed voltage is lower than the minimum complementatary voltage Vcom, the pseudo modules VM are not formed and the process of Fig. 28 is terminated. Further, when the pseudo modules VM cannot be formed, the left-over module EM moves to the lower class α2. Meanwhile, when it is determined in step S504 that the summed voltage is equal to or larger than the minimum complementary voltage Vcom, the pseudo module formation unit 34 forms the pseudo module VM by using the photovoltaic modules M₂ of the class α2 (step S506).

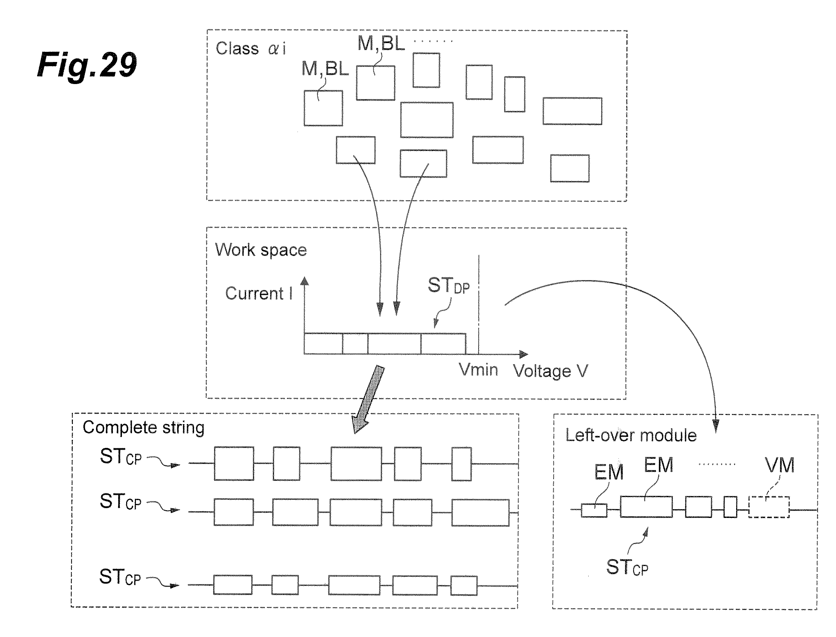

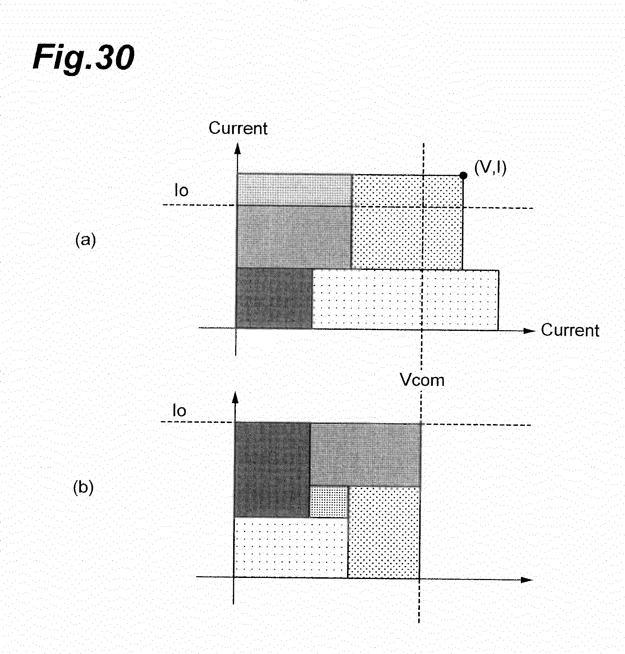

In detail, the pseudo module formation unit 34 finds a combination which satisfies the following conditions by selecting the photovoltaic modules M₂ (the output blocks BL₂) among the class α2 and by combining the photovoltaic modules M₂ in series or in parallel. The condition of the combination to be found is to satisfy that "the minimum complementary voltage Vcom is equal to or lower than the voltage V of the pseudo module" and to satisfy that "the combination has a vertex (V, I) where a distance from the point (Vcom, Io) is the shortest". For example, as illustrated in Fig. 30A, the pseudo module VM formed by the combination of the photovoltaic modules M₂ (the output blocks BL₂) has a vertex (V, I) at an upper right corner. The voltage V of the pseudo module VM is set to be equal to or larger than the minimum complementary voltage Vcom, and the vertex (V, I) is set to be as close to the point (Vcom, Io) as possible. Meanwhile, as illustrated in Fig. 30B, when there is a combination in which the point (Vcom, Io) coincides with the vertex (V, I), the corresponding combination is immediately adopted. When the combination is found, the pseudo module formation unit 34 stores the corresponding result in the memory unit 39. The pseudo module VM formed in this way is connected to the left-over modules EM in series (e.g. See Fig. 29), and the connected modules is stored as one complete string ST_{CP}.

The pseudo module formation unit 34 removes the photovoltaic modules used to make the pseudo module from the lower class α2 (step S508). When the process of step S508 is terminated, the process illustrated in Fig. 28 is terminated.

Referring back to Fig. 25, when the processes of step S410 to step S422 are completed, the complete strings ST_{CP} of the class α1 when the number S1 of series is 5 are determined. Thereafter, the formation of the complete string ST_{CP} of the class α2 is performed. The string formation unit 33 executes a process of forming a string of the class α2 (step S424).

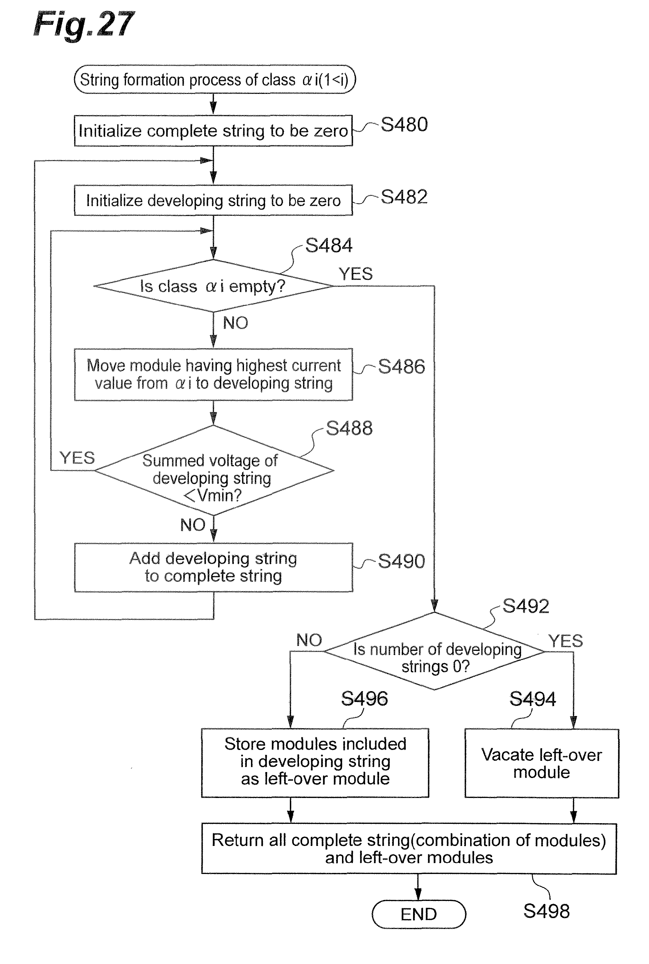

A process of forming a string of the class α2 will be described in detail with reference to Fig. 27. In the class α2, the number of series of the string ST is not set, and the string ST is formed based on the minimum voltage Vmin of the complete string ST_{CP} of the class α1. That is, as illustrated in Fig. 29, the string formation unit 33 forms the complete string ST_{CP} by stacking one by one among the aggregation of the photovoltaic modules M (the output blocks BL) on a coordinate plane of a work space. Further, when there is a left-over module EM, the string formation unit 33 forms the pseudo module VM by the photovoltaic modules M of the class α3, and completes the complete string ST_{CP}. First, the string formation unit 33 initializes the number of the complete strings ST_{CP} within the class α2 to be zero, and initializes the number of modules of a developing string ST_{DP} to be zero (step S482). Next, the string formation unit 33 determines whether there are no photovoltaic modules M₂ in the class α2 (step S484). When it is determined that there are no photovoltaic modules M₂, the process proceeds to a process of step S492.

Meanwhile, when it is determined in step S484 that there is a photovoltaic module M₂ in the class α2, the string formation unit 33 moves a module having the highest current value among the photovoltaic modules M₂ in the class α2, to the developing string ST_{DP} (step S486). As illustrated in Fig. 29, the string formation unit 33 moves a module having the highest current value among the photovoltaic modules M₂ remaining in the class α2 to the work space, and connects the module to the developing string ST_{DP} being made on the coordinate plane, in series. The string formation unit 33 determines whether the summed voltage of the developing string ST_{DP} is lower than the minimum voltage Vmin (step S488). That is, as illustrated in Fig. 29, it is determined whether the voltage of the developing string ST_{DP} is higher than the minimum voltage Vmin. When it is determined in step S488 that the summed voltage is lower than the minimum voltage Vmin, the processes of step S484 to step S488 are performed again, and a new photovoltaic module M₂ is added to the developing string ST_{DP}. Meanwhile, when it is determined in step S488 that the summed voltage is equal to or higher than the minimum voltage Vmin, the string formation unit 33 adds the developing string ST_{DP} in the work space to a memory area (See Fig. 29) of the complete string ST_{CP} (step S490). Thereafter, after step S482 is executed and the work space is initialized, the processes of step S484 to step S490 are repeatedly performed so that a plurality of complete strings ST_{CP} are formed.

When the complete strings ST_{CP} of a certain number are formed, the remainders of the photovoltaic modules M2 in the class α2 are reduced. In this case, the class α2 becomes empty (S490 → S484: YES) immediately after the latest one complete string ST_{CP} is formed, or the class α2 becomes empty (S488 → S484: YES) before the summed voltage of the developing strings ST_{DP} is higher than the minimum voltage Vmin.

After the class α2 becomes empty, the string formation unit 33 determines whether the number of the photovoltaic module M in the developing string ST_{DP} is zero (step S492). That is, it is determined whether the class α2 is empty while the photovoltaic module M remains in the work space or there are no photovoltaic modules M in the work space. When it is determined in step S492 that the number is zero, the string formation unit 33 determines that there are no left-over modules EM in the class α2, to vacate the memory area (See Fig. 29) of the left-over modules EM (step S494). Meanwhile, when it is determined in step S492 that the number is not zero, the photovoltaic modules M included in the developing string ST_{DP} are stored as the left-over modules EM in the memory unit 39 (step S496). By the above-described processes, the string formation unit 33 returns all of the complete strings ST_{CP} (the combination of the modules) and the left-over modules EM (step S498). When the process of step S498 is completed, the process of Fig. 27 is terminated.

Referring back to Fig. 25, the string formation unit 33 determines whether there is a left-over module EM (step S426). When it is determined in step S426 that there is a left-over module EM, the pseudo module formation unit 34 executes a process of forming a pseudo module (step S428), and when it is determined in step S426 that there are no left-over modules EM, step S428 is skipped and the process proceeds to step S430. A process of forming a pseudo module in the class α2 is performed in the same manner as the process of forming the pseudo module in the class α1. Here, the pseudo modules VM are formed by using the photovoltaic modules M₃ of the class α3. The pseudo modules VM are connected to the left-over modules EM in series and the connected modules are stored as one complete string ST_{CP}.

When the processes of step S424 to step S428 are completed, the complete strings ST_{CP} of the class α2 when the number S1 of series is 5 are determined. Thereafter, the formation of the complete string ST_{CP} of the class α3 is performed. The string formation unit 33 executes a process of forming a string of the class α3 (step S430). A process of forming a pseudo module in the class α3 is performed in the same manner as the above-mentioned process of forming the pseudo module in the class α2. The string formation unit 33 determines whether there is a left-over module EM (step S432). When it is determined in step S432 that there is a left-over module EM, the string formation unit 33 does not use the left-over module EM of the class α3 since there is no class lower than the class α3 (step S434), and when it is determined in step S432 that there are no left-over modules EM, the process of step S434 is skipped and the process proceeds to a process of step S436. When the processes of step S430 to step S434 are completed, the complete strings ST_{CP} of the class α3 when the number S1 of series is 5 are determined.

The string formation unit 33 connects all the complete strings ST_{CP} of the classes α1, α2, and α3 in parallel to form an array A, calculates a maximum output operation point Pmax of the corresponding number S1 of series, and stores the maximum output operation point Pmax together with all the complete strings STCP in the memory unit 39 (step S436). Next, the processing unit 38 determines whether the number S1 of series is 7 (step S438). When it is determined in step S438 that the number S1 of series is not 7, 1 is added to the number S1 of series (step S440), and the processes of step S410 to step S438 are performed again by using the new number S1 of series. Accordingly, the maximum output operation point Pmax when the number S1 of series is 6 and 7 and the complete strings ST_{CP} at that time are stored in the memory unit 39. Meanwhile, when it is determined in step S438 that the number S1 of series is 7, the wire connection pattern selection unit 37 compares the maximum output operation points Pmax when the number S1 of series is 5, 6, and 7, and returns all the complete strings ST_{CP} in the number S1 of series when the maximum output operation point Pmax is maximized (step S442). The wire connection pattern selection unit 37 selects a pattern obtained by connecting the complete strings ST_{CP} of the classes in the corresponding number S1 of series in parallel as a wire connection pattern of an array A to be adopted. When the process of step S442 is terminated, the wire connection pattern to be adopted is determined, and the process of Fig. 25 is terminated.

Next, the operation and the effect of the present embodiment will be described.

By the computation device 30, the class classification unit 32 performs the class classification of the photovoltaic modules M based on the parameter including the current value and the voltage value of each of the photovoltaic modules M. That is, since the optimization of the wire connection pattern of each of the classes may be performed by performing the class classification even when the number of the photovoltaic modules M increases, a computation load is reduced as compared with a case of performing computation after organizing the wire connection pattern of the plurality of photovoltaic modules. Accordingly, the wire connection pattern is effectively selected, so that the power generation performance is improved while the computation load is reduced.

Further, the class classification unit 32 classifies the photovoltaic modules M of which the parameters have similar values into the same class. Accordingly, the string ST and the array A may be configured by using the photovoltaic modules M within each of the classes, which have similar characteristics, it becomes easy to perform the optimization of the wire connection pattern, and it becomes easy to form the wire connection pattern which may effectively use an output of each of the photovoltaic modules M without a waste at the same time.

By the computation device 30, it is possible to form a string ST of the class α1 only by the photovoltaic modules M having a large parameter, and form strings ST of the lower classes α2 and α3 only by the photovoltaic modules M having a small parameter. Accordingly, since each of the strings ST is formed by connecting the modules having the similar parameter in series, it is easy to perform the optimization of the wire connection pattern of each of the classes. Further, since a current difference between the modules within each of the strings ST is low, it is easy to increase a maximum output of the array formed by connecting the strings in parallel. That is, it is easy to form not the deformed output assembly AL as illustrated in Fig. 13 but the output assembly AL having a shape similar to a rectangle, and it is easy to increase the maximum output operation point Pmax. Further, the string ST, which can obtain a current value corresponding to that of the string ST of the sunny class, may be formed by using the pseudo modules VM, so that all the photovoltaic modules M may be used without a waste thereof.

Further, in the present embodiment, a sub array is formed at each of the classes such that the voltage to be supplied is satisfied after performing class-classification based on the parameter (the current and the voltage), and one array is configured by connecting the sub arrays in parallel. The wire connection pattern is simply selected by forming arrays in each of the classes to make voltages of the strings similar. Further, in the present embodiment, one power conditioner 3 is provided for the power generation device 2.

Further, the string formation unit 33 connects the photovoltaic modules M belonging to the class α1 in series based on the number S1 of series set for the string ST of the class α1, and the string ST including the left-over modules EM is formed by supplementing the left-over modules EM of which the number is lower than the number S of series with the pseudo module VM. The left-over modules EM of the class α2 may be also supplemented with the pseudo modules VM from the class α3. In this way, even when there is the left-over module EM, the left-over module EM may be supplemented with the pseudo modules VM, so as to contribute to the array output while being prevented from being useless.

Further, the wire connection pattern selection unit 27 selects a wire connection pattern according to the number S1 of series when the maximum output of the array A is maximized among the arrays A formed by connecting the strings ST at each of the numbers S1 of series in parallel. Candidates of the wire connection patterns of the plurality of patterns may be made by only changing the number S1 of series of the string ST, and it is sufficient that an optimal number S1 of series is selected among the candidates, so that a computation load may be extremely reduced and a power generation efficiency may be improved.

Further, the string formation unit 33 forms the strings ST by arranging the photovoltaic modules M belonging to the class α1 in order of the current value, forms the strings of the class α2 by arranging the photovoltaic modules M not used for the pseudo modules VM among the photovoltaic modules M belonging to the class α2 in order of the current value, and forms the strings ST of the class α3 by arranging the photovoltaic modules M not used for the pseudo modules VM among the photovoltaic modules M belonging to the class α3 in order of the current value. Since it is sufficient to arrange the photovoltaic modules M in order of the current value, each of the strings ST may be easily formed. Meanwhile, since the photovoltaic modules M are arranged in order so that a current difference between the photovoltaic modules M in each of the strings ST becomes smaller, it is easy to increase the maximum output of the array A.

### [Fourth embodiment]

The invention according to a fourth embodiment is a photovoltaic power generation simulation system 101 including the computation device 1 as illustrated in Fig. 1. In the photovoltaic power generation system 101, the power generation device 2 corresponds to a device which is generated inside the computation device 1 (or other computation devices) and is virtually set. That is, the photovoltaic module M is a module which is virtually set on software. The computation device 1 of the photovoltaic power generation simulation system 101 may have the same configuration as that of the computation device 1 according to the first embodiment and may perform the same computation process as that of the computation device 1 according to the first embodiment. The corresponding photovoltaic power generation simulation system 101 may select an optimal wire connection pattern, and may adopt the corresponding optimized wire connection pattern when the photovoltaic modules of the actual photovoltaic power generation system are connected.

### [Fifth embodiment]

The invention according to a fifth embodiment is a photovoltaic power generation simulation system 201 including the computation device 20 as illustrated in Fig. 15. In the photovoltaic power generation system 201, the power generation device 2 corresponds to a device which is generated inside the computation device 20 (or other computation devices) and is virtually set. That is, the photovoltaic module M is a module which is virtually set on software. The computation device 20 of the photovoltaic power generation simulation system 201 may have the same configuration as that of the computation device 20 according to the second embodiment and may perform the same computation process as that of the computation device 20 according to the second embodiment. The corresponding photovoltaic power generation simulation system 201 may select an optimal wire connection pattern, and may adopt the corresponding optimized wire connection pattern when the photovoltaic modules of the actual photovoltaic power generation system are connected.

### [Sixth embodiment]

The invention according to a sixth embodiment is a photovoltaic power generation simulation system 301 including the computation device 30 as illustrated in Fig. 24. In the photovoltaic power generation system 301, the power generation device 2 corresponds to a device which is generated inside the computation device 30 (or other computation devices) and is virtually set. That is, the photovoltaic module M is a module which is virtually set on software. The computation device 30 of the photovoltaic power generation simulation system 301 may have the same configuration as that of the computation device 30 according to the third embodiment and may perform the same computation process as that of the computation device 30 according to the third embodiment. The corresponding photovoltaic power generation simulation system 301 may select an optimal wire connection pattern, and may adopt the corresponding optimized wire connection pattern when the photovoltaic modules of the actual photovoltaic power generation system are connected.

The present invention is not limited to the above-mentioned embodiments.

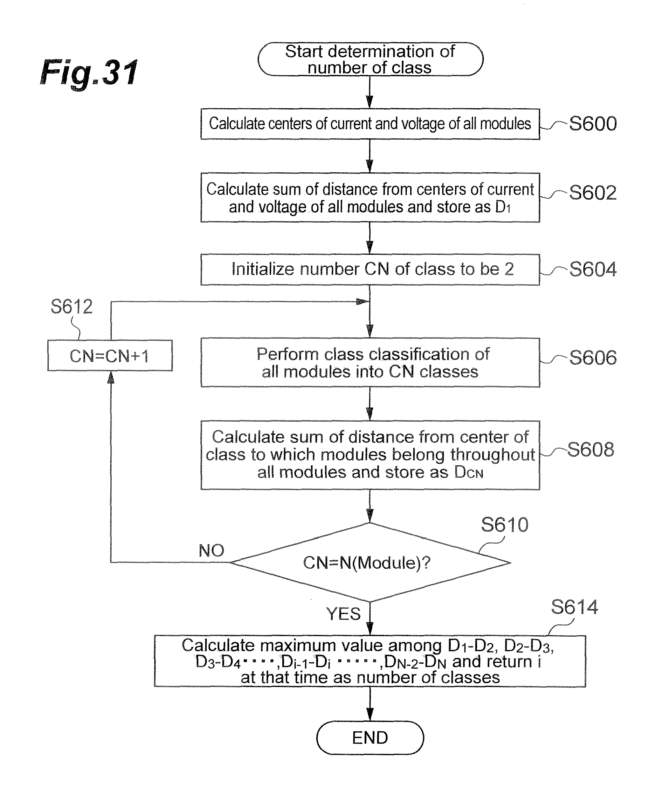

For example, although it is exemplified that the photovoltaic modules are classified into two classes in the first embodiment, and the photovoltaic modules are classified into three classes in the second embodiment and the third embodiment, the number of the class classifications are not particularly limited thereto, and the photovoltaic modules may be classified into more classes (the number of the class classifications of the second embodiment or the third embodiment may be 2). Further, a process of determining the suitable number of the classes may be executed. For example, a process illustrated in Fig. 31 may be executed. Further, the class classification unit calculates a center (current, voltage) of the output blocks BL of all the photovoltaic modules M (step S600). Next, the class classification unit computes distances from the center to centers of all the photovoltaic modules M, calculates the sum of the corresponding distances, and stores the sum as D₁ in the memory unit (step S602). Next, the class classification unit sets an initial value of the number CN of classes to be 2 (step S604). The class classification unit performs the class classification process using CN (equal to 2) classes (step S606). Next, the class classification unit calculates distances between the center of the photovoltaic modules M and centers of the classes to which the photovoltaic modules M belong, with respect to all the photovoltaic modules M, calculates the summed value of the corresponding distance throughout all the modules, and stores the corresponding summed value as D_{CN} (step S608). The class classification unit determines whether the number CN of the classes reaches the number N of modules of the photovoltaic modules M (step S610). When it is determined in step S610 that the number CN of the classes does not reach the number N of modules of the photovoltaic modules M, 1 is added to the number CN of the classes, and the processes of step S606 to step S610 are performed again.

When it is determined in step S610 that the number CN of the classes reaches the number N of modules of the photovoltaic modules M, the class classification unit finds a maximum value among D₁-D₂, D₂-D₃, D₃-D₄, ..., Dᵢ₋₁-Dᵢ, ...,D_{N-1}-D_{N}, and returns i at that time as the number of classes to be adopted (step S614).

A distance from the center of the class which corresponds to the center of the output blocks of each of the photovoltaic modules decreases by increasing the number of classes. Meanwhile, even when the photovoltaic modules are divided into a plurality of classes which exceeds the suitable number, the distance does not excessively decrease, as compared with the increase in the computation load. In the process of Fig. 31, when a distance (deviation) from the center is set as a vertical axis and the number of classes is set as a vertical axis, the number of classes when the deviation decreases most sharply (the number i of classes which is the maximum value among D₁-D₂, D₂-D₃, D₃-D₄, ..., Dᵢ₋₁-Dᵢ, ...D_{N-1}-D_{N}) may be adopted as the suitable number of classes.

Further, although it is exemplified in the above-described embodiments that the number S of series is set to be 5 to 7 based on the allowance voltage of the power conditioner 3, the corresponding number of series is not particularly limited thereto, and may be adequately changed according to the situation. Otherwise, the wire connection pattern may be determined by not changing the number S of series and by setting the number S of series as one value.

Further, although the K-means method is exemplified as the class classification method, the present invention is not limited thereto, and any class classification method such as the nearest neighbor method, the furthest neighbor method, the group average method, the ward method, etc. may be adopted

The optimization of the wire connection pattern in the class may be performed by a method of registering possible wire connection patterns under a restraint condition of the predetermined number of series and selecting a pattern of which the maximum output is maximized among the possible wire connection patterns, or a method of selecting an optimal wire connection pattern while automatically and gradually generating wire connection patterns. The latter method is a method of generating several wire connection states which satisfy initial values in advance and then finding an optimal wire connection pattern by a genetic algorithm and a neural network, as the latter method.

Further, the wire connection selection unit may select a wire connection pattern in which all the photovoltaic modules within the same class are connected to each other in series. In this method, since the optimization of the wire connection has been completed at a time point of terminating the class classification, the computation is easily performed.

Further, the class classification unit may perform the class classification such that the summed value of a standard deviation of parameters of the photovoltaic modules M of the first class and a standard deviation of parameters of the photovoltaic modules M of the second class is lower than a standard deviation of all the photovoltaic modules M when the class classification is not performed.

### Reference Signs List

1, 20, 30: Computation device
2: Power generation device
3: Power conditioner
4: Detection unit
6: Wire connection unit
11, 21, 31: Parameter acquisition unit
12, 22, 32: Class classification unit
13, 23, 33: String formation unit
14, 34: pseudo module formation unit
17, 27, 3 7: Wire connection pattern formation unit
100, 200, 300: Photovoltaic power generation system
101, 201, 301: Photovoltaic power generation simulation system
M: Photovoltaic module
ST: String
A: Array

## Claims

1. A computation device for optimizing photovoltaic power generation by computing a wire connection pattern of a plurality of photovoltaic modules, the computation device comprising:
a parameter acquisition unit configured to acquire a parameter including at least a current value from each of the photovoltaic modules;
a class classification unit configured to perform class classification of the photovoltaic modules based on the parameter acquired by the parameter acquisition unit; and
a wire connection pattern selection unit configured to select the wire connection pattern based on the class classification performed by the class classification unit.

2. The computation device for optimizing photovoltaic power generation according to claim 1, wherein the class classification unit classifies the photovoltaic modules having similar parameters into the same class.

3. The computation device for optimizing photovoltaic power generation according to claim 2, further comprising a string formation unit configured to form a string by connecting the photovoltaic modules in series,
wherein the class classification unit classifies the photovoltaic modules into at least a first class and a second class of which the photovoltaic modules have parameter lower than that of the first class,
the string formation unit forms the strings for classes, and
the wire connection pattern selection unit selects the wire connection pattern based on the strings formed by the string formation unit.

4. The computation device for optimizing photovoltaic power generation according to any one of claims 1 to 3, wherein the wire connection pattern selection unit selects the wire connection pattern such that maximum output of an array configured by wire connection of the photovoltaic modules is maximized.

5. The computation device for optimizing photovoltaic power generation according to claim 3, wherein the string formation unit forms a first string obtained by connecting only the photovoltaic modules belonging to the first class in series, a second string obtained by connecting only the photovoltaic modules belonging to the second class in series, and a third string obtained by connecting the photovoltaic modules belonging to the first class and the photovoltaic modules belonging to the second class, and
the third string is formed by connecting a pseudo module formed by connecting the plurality of photovoltaic modules belonging to the second class based on the parameter of the photovoltaic modules belonging to the first class, and the photovoltaic modules belonging to the first class, in series.

6. The computation device for optimizing photovoltaic power generation according to claim 5, wherein the string formation unit connects the photovoltaic modules belonging to the first class in series based on the number of series set for at least the first string, and
the third string is formed by supplementing the photovoltaic modules belonging to the first class, of which the number is lower than the number of series, with the pseudo modules.

7. The computation device for optimizing photovoltaic power generation according to claim 6, wherein the wire connection selection unit selects a wire connection pattern according to the number of series when a maximum output of an array is maximized, among arrays formed by connecting at least one of the first string, the second string, and the third string in parallel, with respect to a plurality of set numbers of series.

8. The computation device for optimizing photovoltaic power generation according to any one of claims 5 to 7, wherein the string formation unit forms the first string and the third string by arranging the photovoltaic modules belonging to the first class in order of a current value, and forms the second string by arranging the photovoltaic modules not used for the third string among the photovoltaic modules belonging to the second class in order of a current value.

9. The computation device for optimizing photovoltaic power generation according to claim 3, wherein the string formation unit forms a first string obtained by connecting only the photovoltaic modules belonging to the first class in series and a second string obtained by connecting only the photovoltaic modules belonging to the second class in series, and forms the corresponding first string based on a maximum output of an array formed by the first string and the corresponding second string based on a maximum output of an array formed by the second string.

10. The computation device for optimizing photovoltaic power generation according to claim 9, wherein the string formation unit forms the first string by arranging the photovoltaic modules belonging to the first class in order of a current value, and forms the second string by arranging the photovoltaic modules belonging to the second class in order of a current value.

11. The computation device for optimizing photovoltaic power generation according to any one of claims 1 to 4, wherein the wire connection pattern selection unit selects a wire connection pattern in which all the photovoltaic modules within the same class are connected to each other in series.

12. The computation device for optimizing photovoltaic power generation according to any one of claims 1 to 11, wherein a short-circuit current of the photovoltaic modules or a current value at a maximum output operation point is used as the current value.

13. The computation device for optimizing photovoltaic power generation according to any one of claims 1 to 12, wherein the parameter further comprises a voltage value.

14. A photovoltaic power generation system comprising the computation device for optimizing photovoltaic power generation, defined in any one of claims 1 to 13, and a plurality of photovoltaic modules.

15. The photovoltaic power generation system of claim 14, wherein the computation device regularly performs acquisition of the parameter, class classification, and selection of the wire connection pattern.

16. A photovoltaic power generation simulation system for setting a wire connection pattern of a plurality of virtually-set photovoltaic modules by the computation device for optimizing photovoltaic power generation, defined in any one of claims 1 to 13.

17. A method of optimizing photovoltaic power generation by computing a wire connection pattern of a plurality of photovoltaic modules, the method comprising:
acquiring a parameter including at least a current value from each of the photovoltaic modules;
performing class classification of the photovoltaic modules based on the acquired parameter; and
selecting the wire connection pattern based on the performed class classification.
